(19)

**Europäisches Patentamt**
**European Patent Office**
**Office européen des brevets**

(11) **EP 1 942 349 B1**

(12) **EUROPÄISCHE PATENTSCHRIFT**

(45) Veröffentlichungstag und Bekanntmachung des Hinweises auf die Patenterteilung:
**09.06.2010 Patentblatt 2010/23**

(51) Int Cl.:
*G01R 31/3185* (2006.01)  *G01R 31/319* (2006.01)

(21) Anmeldenummer: **08103659.2**

(22) Anmeldetag: **17.06.2005**

(54) **Schaltung zur Komprimierung und Speicherung von Schaltungsdiagnosedaten**

Circuit for compacting and storing circuit test responses

Circuit de compression et de mémorisation de réponses au test de circuits

(84) Benannte Vertragsstaaten:
**DE**

(43) Veröffentlichungstag der Anmeldung:
**09.07.2008 Patentblatt 2008/28**

(62) Dokumentnummer(n) der früheren Anmeldung(en) nach Art. 76 EPÜ:
**05013130.9 / 1 734 375**

(73) Patentinhaber: **Infineon Technologies AG**
**85579 Neubiberg (DE)**

(72) Erfinder:
- **Pöhl, Frank Dr.**
  **81371, München (DE)**
- **Beck, Matthias**
  **81549, München (DE)**
- **Muhmenthaler, Peter**
  **85662, Hohenbrunn (DE)**
- **Rzeha, Jan**
  **16981, Freyenstein (DE)**
- **Gössel, Michael Prof. Dr.**
  **15831, Mahlow (DE)**

(74) Vertreter: **Moore, Joanne Camilla**
**Schweiger & Partner**
**Karlstraße 35**
**80333 München (DE)**

(56) Entgegenhaltungen:
**WO-A-2004/072660    US-A1- 2003 115 525**

- **DMITRIEV A ET AL: "Robust space compaction of test responses" TEST SYMPOSIUM, 2002. (ATS '02). PROCEEDINGS OF THE 11TH ASIAN 18-20 NOV. 2002, PISCATAWAY, NJ, USA,IEEE, 18. November 2002 (2002-11-18), Seiten 254-259, XP010628379 ISBN: 0-7695-1825-7**
- **PATEL J H ET AL: "Application of Saluja-Karpovsky compactors to test responses with many unknowns" VLSI TEST SYMPOSIUM, 2003. PROCEEDINGS. 21ST 27 APRIL - 1 MAY 2003, PISCATAWAY, NJ, USA,IEEE, 27. April 2003 (2003-04-27), Seiten 107-112, XP010638730 ISBN: 0-7695-1924-5**
- **MITRA S ET AL: "X-compact an efficient response compaction technique for test cost reduction" PROCEEDINGS INTERNATIONAL TEST CONFERENCE 2002. ITC 2002. BALTIMORE, MD, OCT. 7-10, 2002, INTERNATIONAL TEST CONFERENCE, NEW YORK, NY : IEEE, US, 7. Oktober 2002 (2002-10-07), Seiten 311-320, XP010609755 ISBN: 0-7803-7542-4**

**Beschreibung**

Die Erfindung betrifft den Test und die Diagnose von großen integrierten elektrischen Schaltungen, wie beispielsweise VLSI-Schaltungen mit einer Vielzahl von während des Testes und während der Diagnose zu überwachenden Ausgängen.

Typisch für moderne VLSI-Schaltungen ist es, dass sie sehr viele Ausgänge und insbesondere viele Ausgänge von Scan-Pfaden aufweisen.

Die DE 195 36 226 A1 zeigt, wie durch das Zuführen eines externen Vergleichsvektors im Testmode Fehler durch direkten Vergleich der tatsächlichen Testresultate an den Ausgängen der Schaltung mit einem der Schaltung zugeführten Vergleichsvektor erkannt werden können. Im Falle eines erkannten Fehlers wird dann zur Diagnose das Resultat des bitweisen Vergleiches wiederum bitweise ausgeschoben. Dabei hat der jeweils von außen zugeführte Vergleichsvektor die gleiche Wortbreite wie der von der getesteten Schaltung ausgegeben Testresponsevektor bzw. die am Schaltungsausgang vorliegenden Testresultate. Für Schaltungen mit vielen Ausgängen ist die in DE 195 36 226 A1 beschriebenen Vorgehensweise dementsprechend aufwendig. Die dabei erforderliche große Wortbreite des zugeführten Testvektors, der bitweise Vergleich für die Vielzahl der zu vergleichenden Bits und, im Falle der Diagnose, das Ausschieben der Vielzahl der Bits ist dabei aufwendig. Das wird deutlich, wenn man Schaltungen mit etwa 1000 bis 2000 Ausgängen betrachtet, die z.B. Ausgänge von Scan-Pfaden sein können. Beim Testen und erst recht beim Diagnostizieren müssen diese Ausgänge überwacht werden. Hinzu kommt, dass die Anzahl der Testinputvektoren häufig ebenfalls in der Größenordnung von mehreren Hundert bis mehreren Tausend Testvektoren liegt.

Nachteilig ist darüber hinaus, dass das in DE 195 36 226 A1 beschriebene Verfahren nicht auf alle Fälle angewendet werden kann.

In DE 100 08 674 B4 ist das Speichern von Diagnosedaten auf einem Chip beschrieben. Dies scheidet jedoch bei modernen Chips aufgrund des zusätzlichen Flächenbedarfs aus.

Die "Robust space compaction of test responses", Dmitriev A. et al, TEST SYMPOSIUM, 2002. 18-20 NOV. 2002, PROCEEDINGS, PISCATAWAY, NJ, USA, IEEE, 18. November 2002, Seiten 254-259, zeigt einen Kompaktor, in dem ein Hemming-Code implementiert ist sowie eine zusätzliche Schaltung, die angibt, ob die Ausgänge der zu testenden Schaltung Werte angeben, die zu der Gruppe von korrekten Testantworten gehört.

In der "Application of Saluja-Karpovsky compactors to test responses with many unknowns", Patel J H et al, VLSI TEST SYMPOSIUM, 2003. PROCEEDINGS. 21 ST 27 April - 1 May 2003, PISCATAWAY, NJ, USA, IEEE, 27. April 2003, Seiten 107-112, wird das Ausmaskieren von unbekannten logischen Werten, den sogenannten X-Werten, offenbart.

Der Erfindung liegt die Aufgabe zugrunde, die genannten Nachteile beim Test und/oder der Diagnose zu vermeiden bzw. zu vermindern und ein verbessertes Test- und Diagnoseverfahren für Schaltungen mit M zu überprüfenden Ausgängen, beispielsweise Ausgängen von M Scan-Pfaden, während des Testes und/oder der Diagnose ausgegebenen Daten anzugeben, wobei M eine große Zahl sein kann.

Diese Aufgabe wird durch den Gegenstand der unabhängigen Patentansprüche gelöst. Vorteilhafte Weiterbildungen ergeben sich aus dem Gegenstand der abhängigen Patentansprüche.

Die Erfindung berücksichtigt, dass die Verifikation einer Schaltung dann besonders kompliziert ist, wenn deren Scan-Pfade als Testantworten auch unbestimmte Werte enthält, deren binäre Werte nicht vorhersehbar sind. Es können auch Tests erfolgen, wenn unbestimmte Werte (sogenannte X-Werte) in den Testantworten der Schaltungen auftreten.

Weiterhin ermöglicht es die Erfindung, die Wortbreite des z.B. vom Tester zugeführten Vergleichsvektors und damit den erforderlichen Aufwand an die gewünschte Fehlerüberdeckung des Testes und der Diagnose anzupassen.

Test und Diagnose der betrachteten Schaltungen erfolgt gemäß der Erfindung mit einer möglichst kleinen Anzahl von zu überwachenden Ausgängen. Test und Diagnose wird auch beim Vorhandensein von unbestimmten Werten mit geringem Aufwand ermöglicht. Darüber hinaus wird im Falle der Diagnose eines Fehlers nur eine kleine Menge von Daten, die die Bestimmung des Fehlers ermöglicht, vom Chip zur Diagnose nach außen ausgegeben.

Erfindungsgemäß werden die M Ausgänge der zu testenden und/oder zu diagnostizierenden Schaltung, in die Testinputs eingegeben werden und die entsprechend M Bit breite Testoutputs liefert, mit den M Testdateneingängen $E_1, ..., E_M$ eines linearen Kompaktors K verbunden. Der Kompaktor K hat des weiteren k Testvergleichseingänge

$v_1^i, \cdots, v_k^i$ und m Testdatenausgänge oder Syndromausgänge $S_1, ... , S_m$. In die k Testvergleichseingänge $v_1^i, \cdots, v_k^i$ werden bei jeder Eingabe eines von der zu testenden und/oder zu diagnostizierenden Schaltung an die Testdateneingänge des Kompaktors gelieferten Testoutputs entsprechend den Testdaten vorherbestimmte, k Bit breite Testvergleichswerte eingegeben. Dabei ist m < M und m ≤ k ≤ M. Der lineare Kompaktor verknüpft die M Bit breiten, an seinen Testdateneingängen eingegebenen Werte durch XOR-Gatter entsprechend den Koeffizienten der H-Matrix eines linearen, fehlerkorrigierenden Kodes und die k an seinen Testvergleichseingängen vom Tester bereitgestellten Vergleichs-

werte $v_1^i, \cdots, v_k^i$ durch weitere XOR-Gatter. Die Verknüpfung erfolgt so, dass im fehlerfreien Fall - d.h. bei Eingabe fehlerfreier Testantworten der Schaltung in die Testdateneingänge des Kompaktors und der durch einen externen Tester bereitgestellten vorbestimmten Vergleichswerte an den k Testvergleichseingängen - an den Ausgängen $S_1$, ... ,$S_m$ des Kompaktors ein charakteristischer Wert ausgegeben wird, der leicht identifiziert werden kann. In einem besonders einfachen Fall wird die Schaltung so ausgelegt, dass im fehlerfreien Fall an den Ausgängen $S_1$, ... , $S_m$ der Wert

$$\underbrace{0,0,...,0}_{m}$$ ausgegeben wird.

Falls die Schaltung S einen Fehler aufweist und falls sie demzufolge einen fehlerhaften Testoutput liefert, dann behandelt der Kompaktor K diese an den M Testeingängen anliegenden Testoutputs gemäß einem durch die H-Matrix bestimmten fehlerkorrigierenden Kode so, dass anstelle der fehlerhaften Testoutputs ein charakteristisches Fehlersyndrom ausgegeben wird. Aus einem solchen Fehlersyndrom kann der Fachmann auf die Ursache des Fehlers schließen.

Wenigstens eine Teilmenge der k Leitungen des Kompaktors, die nach der XOR-Verknüpfung mit den extern bereitgestellten Daten im fehlerfreien Fall den Wert 0 führen, werden darüber hinaus mit den Eingängen eines OR-Gatter verknüpft, dessen binäres Ausgangssignal 1 einen Fehler anzeigt und dessen binäres Ausgangssignal 0 keinen Fehler anzeigt. Dadurch wird eine einfache Fehleranzeige bereitgestellt. Beim Vorliegen eines Fehlersignals 1 am Ausgang diese OR-Gatters können die m Werte die an den m Ausgängen des Kompaktors ausgegeben werden, die das Fehlersyndrom des vorliegenden Fehlers für den betrachteten fehlerkorrigierenden Kode bilden und die es erlauben, die fehlerhaft ausgegeben Test- oder Diagnosedaten allein aus den nur m Bit breiten Werten dieses Fehlersyndroms zu bestimmen. Diese Daten können entweder direkt ausgewertet oder zur späteren Auswertung auf dem Chip oder extern zwischengespeichert werden. In vorteilhaften Ausgestaltungen wird der Kompaktor als ein linearer Kompaktor gewählt. Anstelle des OR-Gatters, das eine Teilmenge der k Leitungen zu einem Fehlersignal verknüpft, kann man auch ein NOR-Gatter verwenden. Im Fehlerfall wird dann der Wert "0" und im fehlerfreien Fall der Wert "1" ausgegeben.

Vorteilhaft ist es dabei, dass zur Diagnose der fehlerhaften Daten nur m Bit breite Syndromvektoren ausgewertet werden müssen und nicht alle M Ausgänge der Schaltung. In vielen praktischen Fällen gilt $m \leq C \log_2(M)$ gilt, wobei C in vielen Fällen eine Konstante zwischen 1 und 2 ist. Also kann man bei z.B. M=1000 Datenausgängen der Schaltung je nach verwendetem fehlerkorrigierenden Kode damit auskommen, nur etwa 10 bis 20 Bits im Fehlersyndrom Syndrom zu betrachten. Dadurch wird die auszuwertende Datenmenge im Fehlerfall also um 98% bis 99% reduziert.

Die Erfindung sieht einen Kompaktor K vor, der auch als Kompaktorschaltung bzw. elektrische Schaltung, die einen Kompaktor implementiert, aufgebaut sein kann. Der Kompaktor weist eine Anzahl M von Testdateneingängen auf, die mit Schaltungsausgängen A einer elektrischen Schaltung S verbunden sind, sowie eine Anzahl k von Testvergleichseingärzgen und eine Anzahl m von Testdatenausgängen. Der Kompaktor K kann als linearer Kompaktor ausgeführt sein. Er weist eine Anzahl von H-Matrix-XOR-Gattern auf, die als Schaltwerk so zwischen den Testdateneingängen und den Testdatenausgängen angeordnet sind, dass die an seinen Testdateneingängen anliegenden Daten entsprechend den Koeffizienten einer H-Matrix eines linearen, fehlerkorrigierenden Kodes komprimiert an den Testdatenausgängen anliegen.

Der Kompaktor K hat weiterhin Kompensations-XOR-Gatter, die im Bereich zwischen den Testdateneingängen und den Testdatenausgängen angeordnet sind, wobei jeweils ein Eingang eines Kompensations-XOR-Gatter zur Eingabe eines auch externen bereitgestellten Kompensationswerts vorgesehen ist. Diese Kompensationswerte können auch kompaktierte Testvergleichswerte sein.

Die erfindungsgemäße Schaltungsanordnung hat eine zu testenden und/oder zu diagnostizierenden elektronische Schaltung S mit einer Anzahl von Schaltungseingängen zur Eingabe von Eingangsdaten bzw. Testinputs und mit einer Anzahl M von Schaltungsausgängen A zur Ausgabe von M Bit breiten Ausgangsdaten bzw. Testoutputs.

Ein auch linearer Kompaktor K mit einer Anzahl M von Testdateneingängen, die mit den Schaltungsausgängen A verbunden sind, sowie mit einer Anzahl k von Testvergleichseingängen und mit einer Anzahl m von Testdatenausgängen ist wie oben beschrieben ausgeführt, wobei der Kompaktor K eine Anzahl von H-Matrix-XOR-Gatter aufweist, die als Schaltwerk so zwischen den Testdateneingängen und den Testdatenausgängen angeordnet sind, dass die an seinen Testdateneingängen anliegenden Daten entsprechend den Koeffizienten einer H-Matrix eines linearen, fehlerkorrigierenden Kodes komprimiert an den Testdatenausgängen anliegen.

Der Kompaktor K hat weiterhin Kompensations-XOR-Gatter, die im Bereich zwischen den Testdateneingängen und den Testdatenausgängen angeordnet sind, wobei jeweils ein Eingang eines Kompensations-XOR-Gatter zur Eingabe eines auch externen Kompensationswerts bzw. kompaktierten Testvergleichswerts vorgesehen ist.

Weiterhin können eine oder mehrere Fehleranzeigeschaltungen vorgesehen sein, deren Eingänge mit wenigstens einem Teil der Leitungen des Kompaktors K verbunden sind und die ein Fehleranzeigesignal f ausgibt. Dabei ist zu bemerken, dass die Erfindung auch funktioniert, wenn nur die Syndromausgänge bzw. nur das Fehleranzeigesignal betrachtet wird. Eine besonders gute Verwirklichung ergibt sich dann, wenn beide Komponenten vorhanden sind, weil dann einfach getestet und trotzdem platzsparend und ökonomisch die evtl. aufgetretenen Fehler betrachtet werden können.

Die Kompensations-XOR-Gatter können in Signalflußrichtung nach den H-Matrix-XOR-Gattern und vor den Testdatenausgängen ($S_1$, ... , $S_m$) angeordnet sein. Alternativ dazu können die Kompensations-XOR-Gatter auch in Signalflußrichtung vor den H-Matrix-XOR-Gattern und nach den Testdateneingängen angeordnet sein. Schließlich ist es auch möglich, die Kompensations-XOR-Gatter in Signalflußrichtung derart zwischen den H-Matrix-XOR-Gattern, den Testdatenausgängen und den Testdateneingängen anzuordnen, dass sich eine vorbestimmte Komprimierungsrate des Testergebnisses und eine vorbestimmte Fehleranzeigewahrscheinlichkeit für einen Fehlerfall ergibt. Die jeweiligen Vor- und Nachteile dieser Varianten sind bei der Beschreibung der ersten Figuren dieser Patentanmeldung genau erläutert und gegeneinander abgewogen.

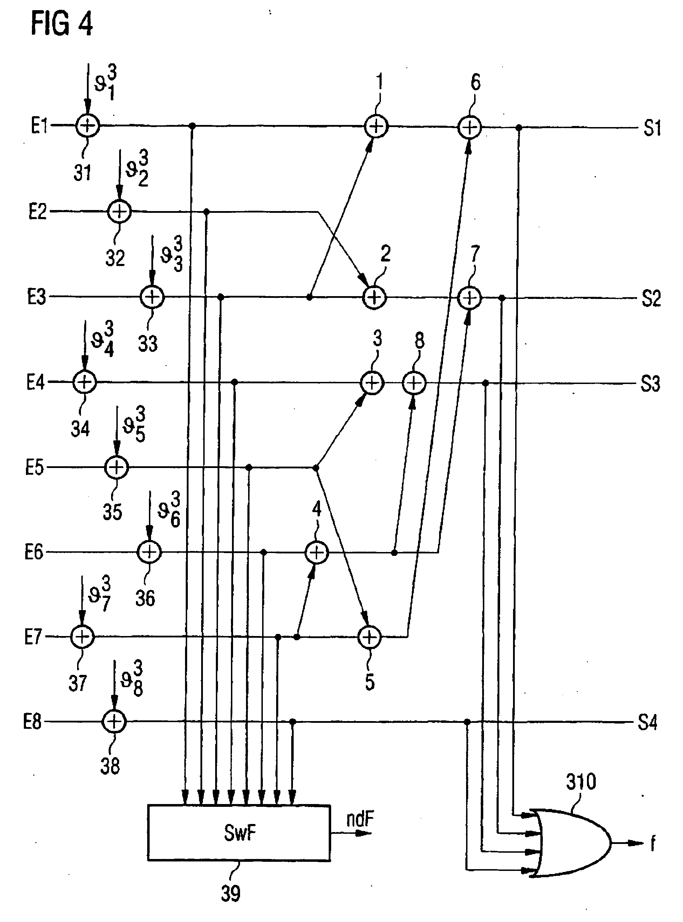

Die Fehleranzeigeschaltung kann einfach als OR-Gatter (91) oder auch als kombinatorisches Schaltwerk (SwF) ausgebildet sein , das ein Fehlersignal (f) dann ausgibt, wenn die Anzahl der an seinen Eingängen anliegenden Fehlersignale einen vorbestimmten Schwellenwert überschreitet, wie es in Fig. 4 erläutert ist.

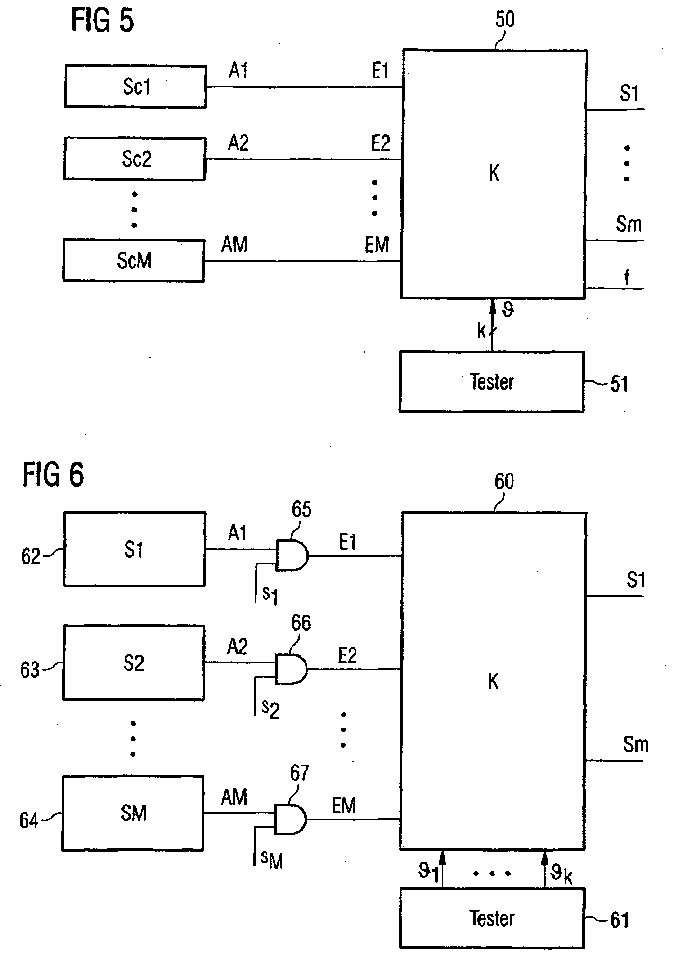

Vor einem oder mehreren Testdateneingängen kann jeweils ein Maskierungseingang zur Eingabe eines vorbestimmten Maskierungssignals vorgesehen sein. Genauso kann vor einem oder mehreren Testdatenausgängen des Kompaktors K je eine Maskierungseinrichtung angeordnet sein, die jeweils einen Maskierungseingang zur Eingabe eines vorbestimmten Maskierungssignals aufweist. Es ist erfindungsgemäß auch möglich, vor einem oder mehreren Kompensations-XOR-Gattern je eine Maskierungseinrichtung anzuordnen, die jeweils einen Maskierungseingang zur Eingabe eines vorbestimmten Maskierungssignals aufweist. Durch diese Maßnahmen können unbestimmte Werte abgefangen und durch einen definierten Wert ersetzt werden, wie z.B. in Fig. 6 erläutert ist.

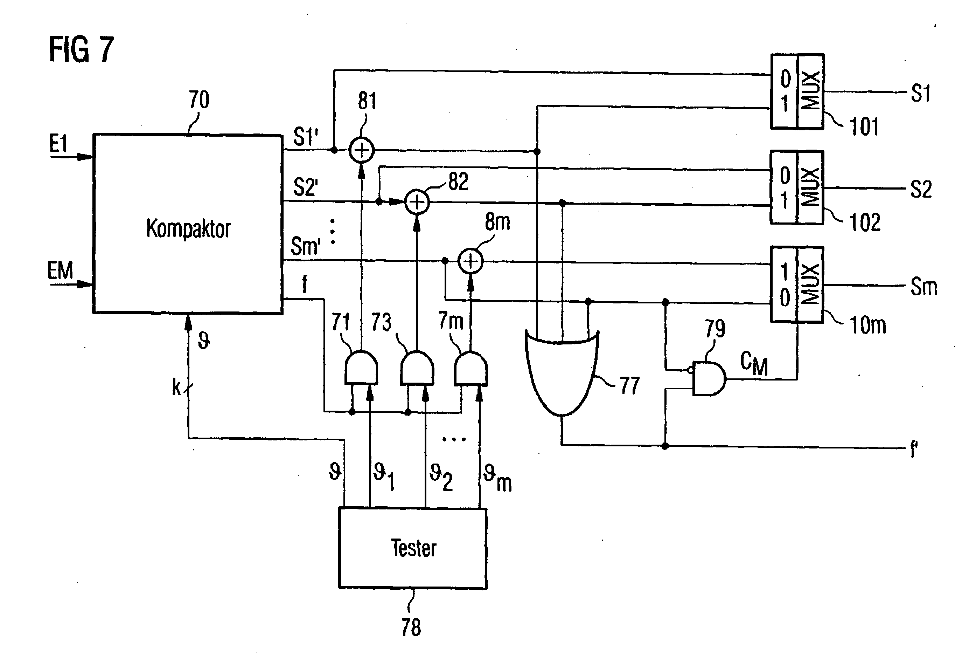

Zur Verarbeitung von X-Werten bietet sich besonders eine erste Schaltung mit m XOR-Gattern, mit m AND-Gattern und mit m Multiplexern an, wobei ein einen Zwischensyndromwert Si' führender Ausgang des Kompaktors K mit dem ersten Eingang eines XOR-Gatters und gleichzeitig mit dem 0-Eingang eines Multiplexers verbunden ist und wobei am zweiten Eingang des XOR-Gatters der Ausgang des AND-Gatters anliegt. Ferner ist in den ersten Eingang des AND-Gatters ein das Fehlersignal f tragender Ausgang des Kompaktors 70 geführt, wie es in Fig. 7 gezeigt ist. Dabei ist von Vorteil, wenn zur Fehleranzeige beim Auftreten solcher X-Werte noch eine zweite Schaltung mit wenigstens einem OR-Gatter und mit wenigstens einem weiteren AND-Gatter vorgesehen ist, wobei der Ausgang des XOR-Gatters gleichzeitig in den 1-Eingang des Multiplexers und in den i-ten Eingang des OR-Gatters geführt ist, das an seinem Ausgang ein Fehlersignal f' ausgibt. Wie mit Bezug auf Fig. 7 erläutert ist, ergibt sich dann eine einfache Fehleranzeige.

Erfindungsgemäß kann wenigstens eine Maskierungseinrichtung auch unmittelbar nach einem Kompensations-XOR-Gatter angeordnet sein, wobei je ein Eingang eines oder mehrerer Kompensations-XOR-Gatter und ein Eingang einer Maskierungseinrichtung so miteinander verbunden sein kann, dass eine gemeinsame Ansteuerung erfolgt.

Die Maskierungseinrichtung kann dabei als OR-Gatter, als AND-Gatter, NOR-Gatter oder als NAND-Gatter ausgebildet sein.

Die Erfindung ist in der Praxis besonders vorteilhaft, wenn die Eingänge E des Kompaktors wenigstens teilweise mit Schaltungsausgängen A der Schaltung S verbunden sind, die als Ausgänge von Scanpfaden ausgebildet sind.

Bei der Fertigung von Halbleiterschaltungen bietet es sich an, die zu testende und ggf. zu diagnostizierende Schaltung S, den Kompaktor K und die Fehleranzeigeschaltung wenigstens teilweise als Bestandteile eines integrierten Schaltkreises auszubilden. Dabei können auch nur Teile dieser Komponenten auf dem gemeinsamen Halbleiterchip angeordnet sein, wenn die übrigen Teile extern bereitgestellt werden.

Ein besonders zeitsparender Fertigungsablauf ergibt sich dann, wenn eine Speichervorrichtung für die sich an den Testdatenausgängen ergebenden Daten vorgesehen ist. So können eine Vielzahl von Schaltungen getestet werden, wobei die zunächst anhand des Fehlersignals f als fehlerhaft ausgegebenen Schaltungen von der Auslieferung zurückgestellt werden können, bis sie genauer betrachtet werden können. Zur genauen Betrachtung brauchen dabei nicht alle Tests wiederholt werden, sondern es reicht aus, sich die abgespeicherten Testergebnisse zu betrachten.

Es braucht nicht in Einzelnen ausgeführt werden, dass Ergänzungen, die die einfachste Ausführungsform der erfindungsgemäßen Schaltungsanordnung betreffen, auch auf den Kompaktor selbst in seiner einfachsten Ausführungsform angewendet werden können.

Genauso ist das Konzept der Erfindung nicht auf Ausführungsformen beschränkt, bei denen die in den Ausführungsbeispielen angegebenen Signalformen entstehen. So kann eine Schaltung vorgesehen werden, bei der ein den fehlerfreien Fall anzeigendes Syndrom Werte von "1" anstelle der "0"-Werte aufweist. Genauso kann das den fehlerfreien Fall anzeigende Signal f den Wert "1" haben. Der Fachmann passt dazu einfach den Grundgedanken der Erfindung an diese Vorgaben an, indem er passende logische Gatter vorsieht.

Eine erfindungsgemäße Testanordnung mit einer vorstehend beschriebenen Schaltungsanordnung weist einen externen Tester T auf, der an den Eingängen einer Schaltung S vorbestimmte Testeingangswerte bereitstellt, und der an den Kompensationseingängen des Kompaktors k Bit breite, vorbestimmte Kompensationswerte bereitstellt und der an etwaigen Maskierungseingängen vorbestimmte Maskierungssignale bereitstellt.

Der Tester T, der an den Eingängen mehrerer gleicher Schaltungen S vorbestimmte Testeingangswerte bereitstellt, und der an den Kompensationseingängen der Kompaktoren K bei diesen Schaltungen S k Bit breite, vorbestimmte Kompensationswerte bereitstellt und der an etwaigen Maskierungseingängen dieser Schaltungen vorbestimmte Maskierungssignale bereitstellt, erlaubt ein besonders zeitsparendes Testen.

Beim Betreiben, d.h. zum Testen oder zum nachfolgenden Diagnostizieren, einer elektronischen Schaltung S mit einer Anzahl von Schaltungseingängen zur Eingabe von Eingangsdaten bzw. Testinputs und mit einer Anzahl M von Schaltungsausgängen A zur Ausgabe von M Bit breiten Ausgangsdaten bzw. Testoutputs wird zunächst ein auch linearen Kompaktor K mit einer Anzahl M von Testdateneingängen bereitgestellt, die mit den Schaltungsausgängen A verbunden sind, sowie mit einer Anzahl k von Testvergleichseingängen und mit einer Anzahl m von Testdatenausgängen.

Der lineare Kompaktor K weist eine Anzahl von H-Matrix-XOR-Gattern auf, die als Schaltwerk so zwischen den Testdateneingängen und den Testdatenausgängen angeordnet sind, dass die an seinen Testdateneingängen anliegenden Daten entsprechend den Koeffizienten einer H-Matrix eines linearen, fehlerkorrigierenden Kodes komprimiert an den Testdatenausgängen anliegen.

Der Kompaktor K hat weiterhin Kompensations-XOR-Gatter, die im Bereich zwischen den Testdateneingängen und den Testdatenausgängen angeordnet sind, wobei jeweils ein Eingang eines Kompensations-XOR-Gatter zur Eingabe eines auch externen Kompensationswerts (bzw. kompaktierten Testvergleichswerts) vorgesehen ist.

Anschließend werden eine Anzahl von Testdaten als Menge von einander zugeordneten Eingangsdaten bzw. Testinputs berechnet, ebenso Ausgangsdaten bzw. Testoutputs und Kompensationswerte, wobei die Kompensationswerte so erzeugt werden, dass bei einer Übereinstimmung der tatsächlichen Ausgangsdaten mit den zu erwartenden Ausgangsdaten an den Testdatenausgängen ein vorbestimmtes Signalmuster erzeugt wird.

Daneben werden eine oder mehrere Fehleranzeigeschaltungen bereitgestellt, deren Eingänge mit wenigstens einem Teil der Leitungen des Kompaktors K verbunden sind und die ein Fehleranzeigesignal (f) ausgeben, wenn an den Testdatenausgängen ein anderes Signal als das für den fehlerfreien Fall vorgesehene Signalmuster auftritt.

Zum Testen oder zum Diagnostizieren werden die Schaltungseingänge schließlich mit den Eingangsdaten beaufschlagt.

In einem Testmodus werden die Schaltungseingänge so lange mit Eingangsdaten beaufschlagt, bis alle Eingangsdaten verarbeitet sind, wobei festgehalten wird, ob bei einem oder mehreren Eingangsdaten ein Fehleranzeigesignal aufgetreten ist.

In einem Testmodus können die Schaltungseingänge auch so lange mit Eingangsdaten beaufschlagt werden, bis ein Fehleranzeigesignal (f) auftritt. Danach wird der Test angehalten.

In einem Diagnosemodus können Eingangsdaten an den Schaltungseingängen angelegt werden, bei denen ein Fehleranzeigesignal auftritt, wobei die an den Testdatenausgängen anliegenden Daten aufgezeichnet und evtl. später ausgewertet werden.

Zum erfindungsgemäßen Betreiben einer elektronischen Schaltung werden die an den Testdateneingängen auftretenden Daten im Bereich der getesteten Schaltung abgespeichert und evtl. später ausgelesen.

Die Erfindung betrifft auch ein in einer Testeinrichtung ablaufendes Computerprogramm zum Ausführen eines Verfahrens zum Testen eines integrierten Schaltkreises, das so ausgebildet ist, dass die vorhergehenden Verfahrensschritte ausführbar sind. Das Computerprogramm kann auf einem Speichermedium, insbesondere in einem Computerspeicher oder in einem Direktzugriffsspeicher, enthalten sein, auf einem elektrischen Trägersignal übertragen werden. Dadurch wird auch ein solcher Datenträger mit einem erfindungsgemäßen Computerprogramm zu einer Erfindung. Selbstverständlich umfasst die Erfindung auch ein Verfahren, bei dem ein Computerprogramm nach Anspruch 24 aus einem elektronischen Datennetz wie bspw. aus dem Internet auf einen an das Datennetz angeschlossenen Computer heruntergeladen wird.

Im Gegensatz zum Stand der Technik sind bei der Erfindung zur Diagnose nur die m Bits des Syndromes des Kodes erforderlich und nicht die Wortbreite M aller M Ausgänge, m < M. Die zur Diagnose erforderlichen Werte sind kompaktiert auf ein Syndrom eines fehlerkorrigierenden Kodes, so dass nur k in beliebiger Abstufung von m bis M und nicht notwendig M Bit breite Vergleichswerte vom Tester bereitgestellt werden müssen. Die Diagnosedaten können auf dem Chip gespeichert werden und X-Werte können in unterschiedlicher Form behandelt werden. Die Testschärfe ist durch k beliebig bis 100% (für k= M) variierbar. Für M = 1000 erhält man in praktischen Fällen m < 20.

Erfindungsgemäß schließt sich erst nach der Fehlererkennung die Diagnose der Schaltung an.

Die Erfindung ist in der Zeichnung anhand mehrerer Ausführungsbeispiele veranschaulicht.

Fig. 1    zeigt eine erfindungsgemäße Kompaktorschaltung,
Fig. 2    zeigt eine weitere erfindungsgemäße Kompaktorschaltung,
Fig. 3    zeigt eine weitere erfindungsgemäße Kompaktorschaltung,
Fig. 4    zeigt eine weitere erfindungsgemäße Kompaktorschaltung,
Fig. 5    zeigt eine weitere erfindungsgemäße Kompaktorschaltung zusammen mit einer zu testenden und zu diagnostizierenden Schaltung, die Scanpfade aufweist,
Fig. 6    zeigt eine weitere erfindungsgemäße Kompaktorschaltung zusammen mit einer weiteren zu testenden und zu diagnostizierenden Schaltung, die Scanpfade aufweist,

Fig. 7    zeigt einen weiteren erfindungsgemäßen Kompaktor, der mit einem Tester zusammengeschaltet ist,

Fig. 8    zeigt einen weiteren erfindungsgemäßen Kompaktor, der einen Speicher aufweist,

Fig. 9    zeigt einen weiteren erfindungsgemäßen Kompaktor, der einen weiteren Speicher aufweist,

Fig. 10    zeigt eine weitere erfindungsgemäße Kompaktorschaltung,

Fig. 11    zeigt eine weitere erfindungsgemäße Kompaktorschaltung,

Fig. 12    zeigt eine Vielzahl von weiteren erfindungsgemäßen Kompaktoren, die mit einem einzigen Tester zusammengeschaltet sind,

Fig. 13    zeigt eine Schaltung, die an einen weiteren erfindungsgemäßen Kompaktor angeschlossen ist, wobei ein Tester Testdaten für die Schaltung sowie Vergleichsdaten und Kompensationsdaten für den Kompaktor liefert.

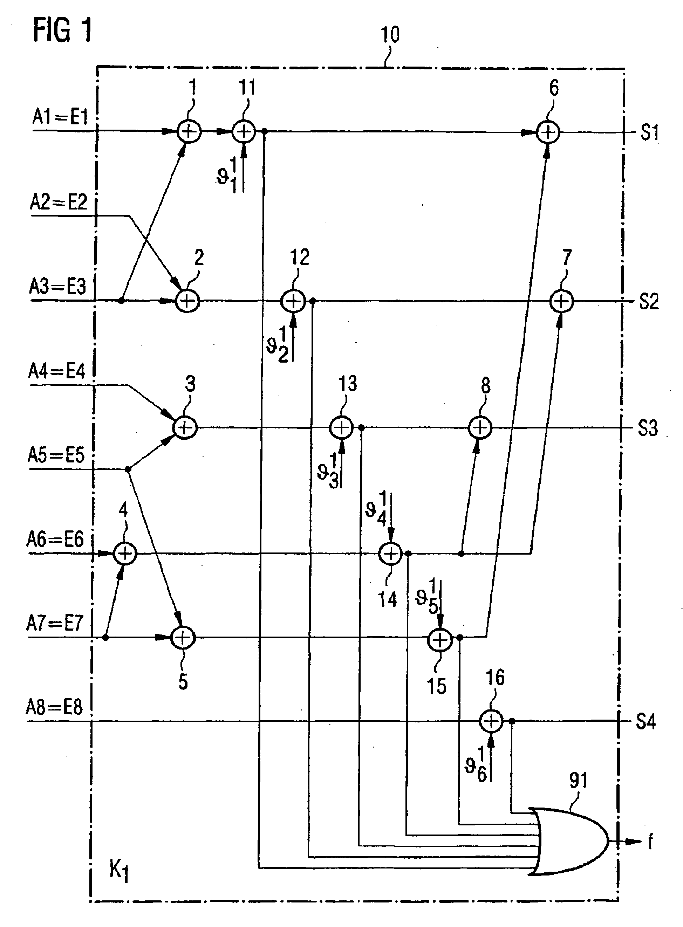

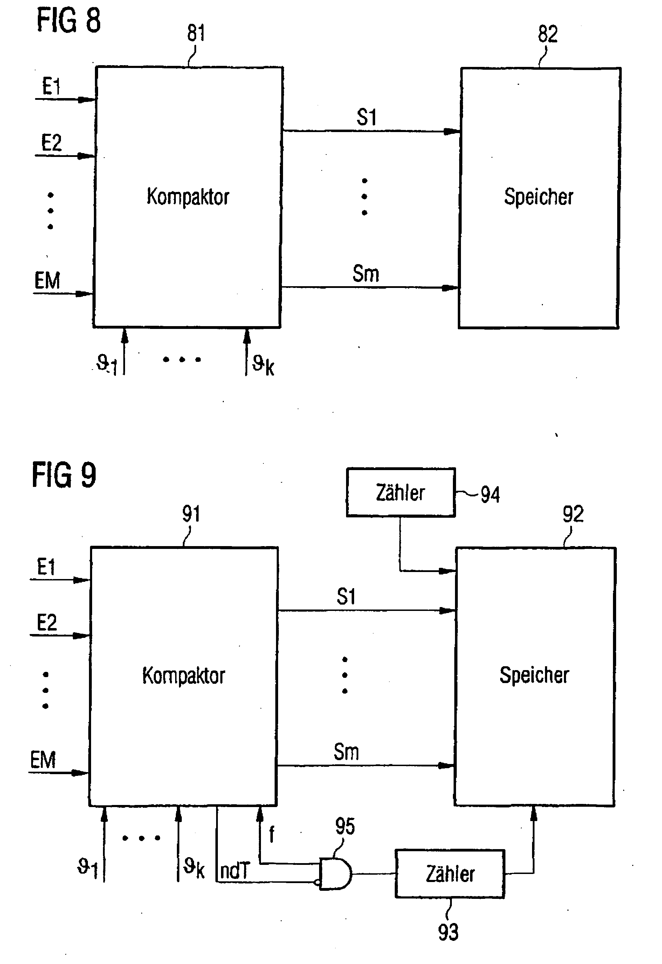

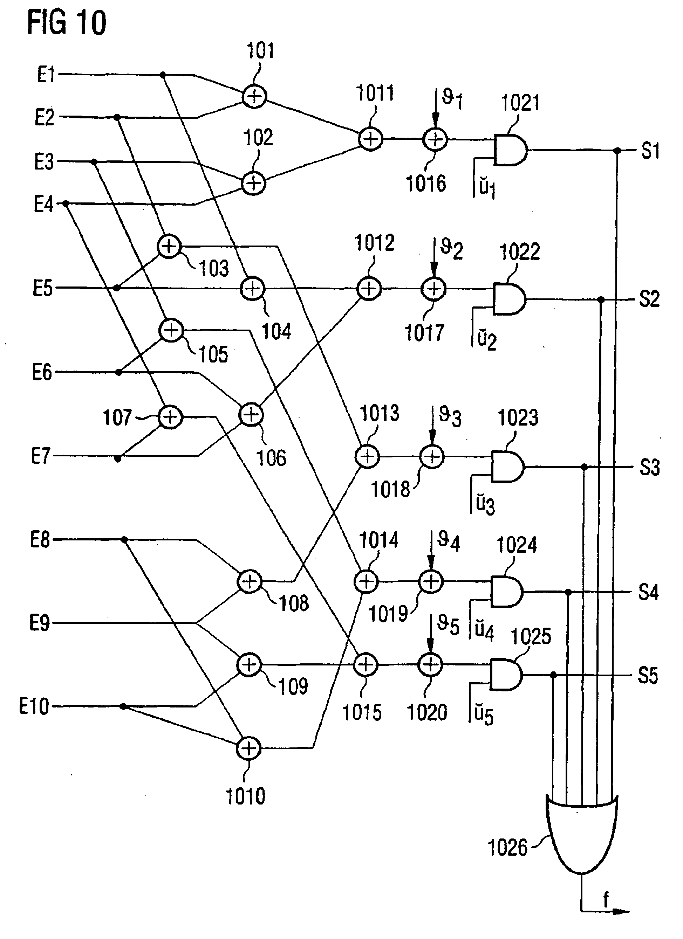

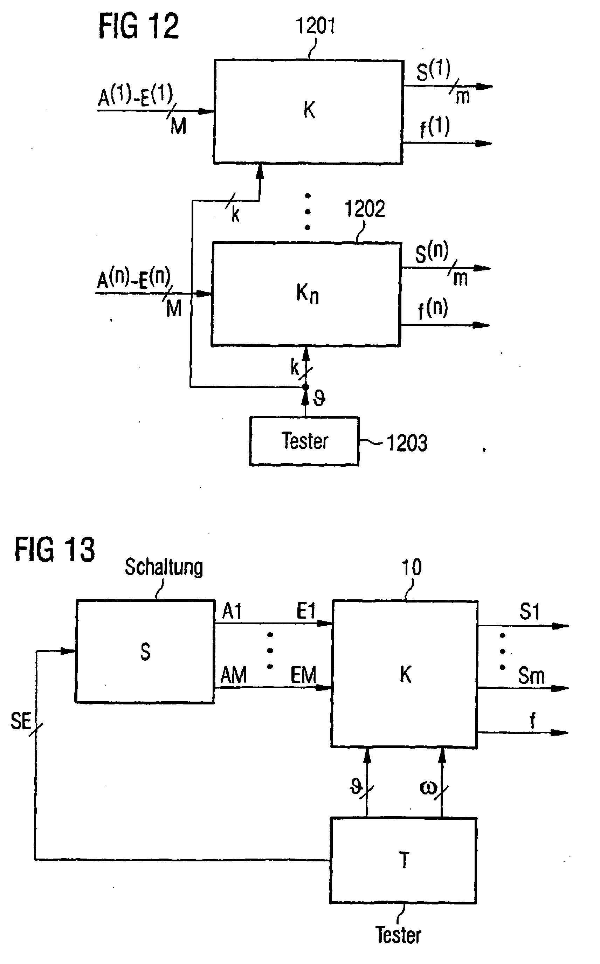

Besonders ökonomisch lässt sich die Beschreibung der Figuren dann lesen, wenn mit der Lektüre der Beschreibung von Fig. 13 begonnen wird. Danach sollten die Beschreibungen zu den Figuren 1 bis 7 sowie zu den Figuren 10 bis 12 gelesen werden. Erst danach sollten die Beschreibungen zu den Figuren 8 und 9 gelesen werden. Fachleute verstehen die Beschreibung zu den einzelnen Figuren selbstverständlich auch, wenn diese in einer beliebigen Reihenfolge gelesen werden.

Fig. 1 zeigt eine erfindungsgemäße Kompaktorschaltung $K_1$ 10 zum Test und zur Diagnose einer Schaltung S mit 8 Ausgängen A1, A2, ... , A8. Als fehlerkorrigierender Kode, vorzugsweise ein linearer Kode, wird ein verkürzter Hamming-Kode mit der Kontrollmatrix H benutzt, die auch als Paritätsprüfmatrix bezeichnet wird, wobei:

$$H = \begin{pmatrix} 1 & 0 & 1 & 0 & 1 & 0 & 1 & 0 \\ 0 & 1 & 1 & 0 & 0 & 1 & 1 & 0 \\ 0 & 0 & 0 & 1 & 1 & 1 & 1 & 0 \\ 0 & 0 & 0 & 0 & 0 & 0 & 0 & 1 \end{pmatrix}$$

Hamming-Kodes und verkürzte Hamming-Kodes sind einem Fachmann gut bekannt und zum Beispiel in Peterson, W., "Prüfbare und korrigierbare Kodes", Oldenburg Verlag München und Wien, 1967, beschrieben.

Die Kompaktorschaltung $K_1$ hat die M = 8 Testdaten-Eingänge E1, E2, ... , E8, die weiteren k = 6 Vergleichs-Eingänge $v_1^I, \cdots, v_6^I$, die m = 4 Syndrom-Ausgänge S1, S2, S3, S4 und den Fehlersignal-Ausgang f. Die Ausgänge A1, A2, ... , A8 der zu testenden und zu diagnostizierenden Schaltung, die in Fig. 1 nicht eingezeichnet ist, sind mit den entsprechenden Testdaten-Eingaängen E1, E2, ... ,E8 der Kompaktorschaltung K1 10 verbunden.

Die Werte der Syndromausgänge S1, S2, S3, S4 sind durch die folgende Gleichung festgelegt:

$$\begin{pmatrix} S1 \\ S2 \\ S3 \\ S4 \end{pmatrix} = H \begin{pmatrix} E1 \\ E2 \\ E3 \\ E4 \\ E5 \\ E6 \\ E7 \\ E8 \end{pmatrix} \oplus \begin{pmatrix} v_1^I \oplus v_5^I \\ v_2^I \oplus v_4^I \\ v_3^I \oplus v_4^I \\ v_6^I \end{pmatrix}$$

Der Fehlerausgang f ist durch die folgende Gleichung festgelegt:

$$f = (E1 \oplus E3 \oplus v_1^1) \vee (E2 \oplus E3 \oplus v_2^1) \vee (E4 \oplus E5 \oplus v_3^1)$$
$$\vee (E6 \oplus E7 \oplus v_4^1) \vee (E5 \oplus E7 \oplus v_5^1) \vee (E8 \oplus v_6^1)$$

Das symbol $\oplus$ steht dabei für eine XOR-Verknüpfung der an den jeweiligen Leitungen anliegenden Signale.

Für die Komponenten der Signaturen erhält man daraus:

$$S1 = E1 \oplus E3 \oplus E5 \oplus E7 \oplus v_1^1 \oplus v_5^1$$

$$S2 = E2 \oplus E3 \oplus E6 \oplus E7 \oplus v_2^1 \oplus v_4^1$$

$$S3 = E4 \oplus E5 \oplus E6 \oplus E7 \oplus v_3^1 \oplus v_4^1$$

$$S4 = E8 \oplus v_6^1$$

Die k= 6 binären, vom Tester bereitgestellten Vergleichswerte $v_1^1, \cdots, v_6^1$ sind durch

$$v_1^1 = E1 \oplus E3$$

$$v_2^1 = E2 \oplus E3$$

$$v_3^1 = E4 \oplus E5$$

$$v_4^1 = E6 \oplus E7$$

$$v_5^1 = E5 \oplus E7$$

$$v_6^1 = E8$$

definiert.

Man bemerkt, dass gerade diejenige Teilmenge der Leitungen , die mit den Eingängen des hier als Fehleranzeigevorrichtung vorgesehenen OR-Gatters 91 verknüpft werden, im fehlerfreien Fall den wert 0 führen. Es sind dies die Ausgangsleitungen der XOR-Gatter 11,12,13,14,15 und 16, die durch die vom Tester bereitgestellten Vergleichswerte zu 0 kompensiert werden.

Die Schaltung aus Fig. 1 ist als integrierte Halbleiterschaltung auf einem Halbleitersubstrat aufgebaut, auf dem auch die zu verifizierende Schaltung S vorgesehen ist.

Die Schaltung von Fig. 1 soll nun noch im Einzelnen beschrieben werden. Der Eingang E1 ist mit dem ersten Eingang des XOR-Gatters 1 verbunden und dessen zweiter Eingang ist mit dem Eingang E3 verbunden. Der Ausgang des XOR-Gatters 1 ist in den in den ersten Eingang des XOR-Gatters 11 geführt. An dem zweitem Eingang des XOR-Gatters 1 liegt der binäre Vergleichswert $v_1^1$ eines hier nicht gezeigten Testers an und der Ausgang des XOR-Gatters 1 ist in den ersten Eingang eines XOR-Gatters 6 geführt. Dessen Ausgang trägt die erste Komponente S1 des Syndromes bzw. Fehlersyndroms.

Der Eingang E2 ist mit dem ersten Eingang eines XOR-Gatters 2 verbunden, dessen zweiter Eingang mit dem Eingang E3 verbunden ist. Dessen Ausgang ist in den ersten Eingang eines XOR-Gatters 12 geführt und an dessen zweitem Eingang liegt der vom Tester bereitgestellte binäre Vergleichswert $v_2^1$ an. Der Ausgang des XOR-Gatters 13 ist in den ersten Eingang eines XOR-Gatters 7 geführt, und dessen Ausgang trägt die zweite Komponente S2 des Syndroms.

Der Eingang E4 ist mit dem ersten Eingang des XOR-Gatters 3 verbunden, dessen zweiter Eingang mit dem Eingang E5 verbunden ist. Dessen Ausgang ist in den ersten Eingang des XOR-Gatters 13 geführt und an dessen zweitem Eingang der vom Tester bereitgestellte binäre Vergleichswert $v_3^1$ anliegt. Der Ausgang des XOR-Gatters 13 wird in den ersten Eingang eines XOR-Gatters 8 geführt, und dessen Ausgang trägt die dritte Komponente S3 des Syndroms. Der zweite Eingang des XOR-Gatters 8 wird nachfolgend mit Bezug auf den Eingang E6 beschrieben.

Der Eingang E5 ist mit dem ersten Eingang des XOR-Gatters 5 verbunden, dessen zweiter Eingang mit dem Eingang E7 verbunden ist. Der Ausgang des XOR-Gatters 5 ist in den ersten Eingang des XOR-Gatters 15 geführt. An dessen zweitem Eingang liegt der vom Tester bereitgestellte binäre Vergleichswert $v_5^1$ an. Der Ausgang des XOR-Gatters 15 ist in den zweiten Eingang des XOR-Gatters 6 geführt ist.

Der Eingang E6 ist mit dem ersten Eingang eines XOR-Gatters 4 verbunden, dessen zweiter Eingang mit dem Eingang E7 verbunden ist. Der Ausgang des XOR-Gatters 4 ist in den ersten Eingang eines XOR-Gatters 14 geführt. An dessen zweitem Eingang liegt der vom Tester bereitgestellte binäre Vergleichswert $v_4^1$ an. Der Ausgang des XOR-Gatters 14 ist in den zweiten Eingang des XOR-Gatters 7 geführt.

Der Eingang E8 ist mit dem ersten Eingang eines XOR-Gatters 16 verbunden, an dessen zweitem Eingang der vom Tester bereitgestellte binäre Vergleichswert $v_6^1$ anliegt. Der Ausgang des XOR-Gatters 16 trägt die vierte Komponente S4 des Syndroms.

Die Ausgangsleitungen der XOR-Gatter 1, 2, 3, 4, 5 und die Eingangsleitung E8 werden somit in den XOR-Gattern 11, 12, 13, 14, 15, 16 mit den vom Tester bereitgestellten Werten $v_1^1, \cdots, v_1^6$ XOR-verknüpft.

Die Ausgänge der XOR-Gatter 11, 12, 13, ..., 16 führen im fehlerfreien Fall den Wert "0", denn deren jeweilige Eingänge sind dann jeweils gleich.

Eine Teilmenge der Leitungen des Kompaktors $K_1$, die mit den XOR-Gattern 11, ..., 16 so kompensiert worden sind, dass die Ausgänge dieser XOR-Gatter im fehlerfreien Fall ständig den Wert "0" ergeben, werden mit den Eingängen eines OR-Gatters 91 verknüpft.

Der Ausgang des OR-Gatters 91 zeigt dann "1" als Fehlersignal, wenn mindestens einer seiner Eingänge den Wert "1" führt.

Man bemerkt, dass die k= 6 Leitungen nach der XOR-Verknüpfung mit den Vergleichswerten $v_1^1, \cdots, v_6^1$ den Wert 0 führen, solange kein Fehler auftritt. Man bemerkt weiterhin, dass dann, wenn diese Leitungen jeweils den Wert 0 führen, auch die m = 4 Ausgänge S1, S2, S3, S4 des Kompaktors $K_1$ jeweils den Wert 0 führen.

Die XOR-Gatter des Kompaktors K1, die die an seinen Eingängen anliegenden Werte entsprechend den Koeffizienten der H-Matrix des betrachteten fehlerkorrigierenden Kodes verknüpfen, sind hier die XOR-Gatter 1,2,3,4,5,6,7 und 8. Sie werden als H-Matrix-XOR-Gatter bezeichnet. So ist der Syndromausgang S1 über die XOR-Gatter 1,5 und 6 mit den Eingängen E1, E3, E5 und E7 entsprechend der ersten Zeile 10101010 der H-Matrix verknüpft. Diese Zeile hat an der ersten, dritten, fünften und siebenten Stelle den Wert 1. Dies Positionen entsprechen den Eingängen, die über diese H-Matrix-XOR-Gatter verknüpft werden.

Entsprechend der zweiten Zeile der H-Matrix 01100110, die an den Positionen 2, 3, 6 und 7 eine 1 aufweist, sind die Eingänge E2, E3, E6 und E7 über die H-Matrix-XOR-Gatter 2,4 und 7 zu dem Syndromausgang s2 verknüpft.

Entsprechend der dritten Zeile der H-Matrix 00011110, die an den Positionen 4,5,6 und 7 eine 1 aufweist sind die Eingänge e4, e5, e6 und E7 über die H-Matrix-XOR-Gatter 3, 4 und 8 zu dem Syndromausgang S3 verknüpft.

Die vierte Zeile der H-Matrix 00000001 weist nur an der 8-ten Stelle den Wert 1 auf, und der Eingang E8 ist mit dem Syndromausgang S4 verbunden, ohne dass eine XOR-Verknüpfung dieses 8-ten Einganges mit einem weiteren Eingang erforderlich ist.

Die weiteren XOR-Gatter 11,12, 13, 14, 15 und 16 sind Kompensations-XOR-Gatter. An ihren jeweils zweiten Eingängen liegen die entsprechenden Vergleichswerte an, die vom Tester bereitgestellt werden.

Die Funktionsweise der Kompaktors K1 zum Test und zur Diagnose soll nun für verschiedene zu verarbeitende Daten erläutert werden. Die vom Tester bereitgestellten Werte werden nachfolgend der Einfachheit halber mit v1 bis v6 bezeichnet. Das XOR-Symbol ⊕ wird nachfolgend der Einfachheit halber mit "XOR" bezeichnet.

Zu einem betrachteten ersten Zeitpunkt t sei die korrekte Ausgabe der zu testenden und zu diagnostizierenden Schaltung als Antwort auf eine entsprechende Testeingabe beispielsweise mit A1=1, A2=1, A3=0, A4=1, A5=0, A6=0, A7=0, A8=1 angenommen. Die Ausgänge Ai sind mit den Eingängen Ei für i= 1, ... ,8 verbunden, so dass an den Eingängen des Kompaktors die Werte E1 =1, E2= 1, E3= 0, E4= 1, E5= 0, E6= 0,E7 = 0, E8 = 1 anliegen. Am Ausgang des XOR-Gatters 1 wird der Wert $E1 \oplus E3 = 1 \oplus 0 = 1$ gebildet, der am ersten Eingang des XOR-Gatters 11 anliegt. Um am Ausgang des XOR-Gatters 11 den Wert 0 zu erzeugen, ist daher der Wert v1 = 1 an den zweiten Eingang des XOR-Gatters 11 anzulegen. Dieser Wert v1 = 1 wird in diesem Zeitpunkt t vom externen Tester bereitgestellt. Am Ausgang des XOR-Gatters 2 wird der Wert E2 XOR E3 = 1 XOR 0 = 1 gebildet, der am ersten Eingang des XOR-Gatters 12 anliegt. Um am Ausgang des XOR-Gatters 12 den Wert 0 zu erzeugen, ist daher der Wert v2 = 1 an den zweiten Eingang des XOR-Gatters 12 anzulegen. Dieser Wert v2 = 1 wird in diesem Zeitpunkt t vom externen Tester bereitgestellt. Am Ausgang des XOR-Gatters 3 wird der Wert E4 XOR E5 = 1 XOR 0 = 1 gebildet, der am ersten Eingang des XOR-Gatters 13 anliegt. Um am Ausgang des XOR-Gatters 13 den Wert 0 zu erzeugen, ist daher der Wert v3 = 1 an den zweiten Eingang des XOR-Gatters 13 anzulegen. Dieser Wert v3 = 1 wird in diesem zeitpunkt t vom externen Tester bereitgestellt. Am Ausgang des XOR-Gatters 4 wird der Wert E6 XOR E7 = 0 XOR 0 = 0 gebildet, der am ersten Eingang des XOR-Gatters 14 anliegt. Um am Ausgang des XOR-Gatters 14 den Wert 0 zu erzeugen, ist daher der Wert v4 = 0 an der zweiten Eingang des XOR-Gatters 14 anzulegen. Dieser Wert v1 = 0 wird in diesem Zeitpunkt t vom externen Tester bereitgestellt. Am Ausgang des XOR-Gatters 5 wird der Wert E5 XOR E7 = 0 XOR 0 = 0 gebildet, der am ersten Eingang des XOR-Gatters 15 anliegt. Um am Ausgang des XOR-Gatters 15 den Wert 0 zu erzeugen, ist daher der Wert v5 = 0 an der zweiten Eingang des XOR-Gatters 15 anzulegen. Dieser Wert v5 = 0 wird in diesem Zeitpunkt t vom externen Tester bereitgestellt. Um am Ausgang des XOR-Gatters 16 den Wert 0 zu erzeugen, ist an den zweiten Eingang dieses XOR-Gatters der Wert v6 = 1 vom externen Tester bereitzustellen, damit der an seinem ersten Eingang anliegende Wert E8 = 1 zu 1 XOR 1 = 0 verknüpft wird. Die Ausgänge des XOR-Gatter 11, 12, 13, 14, 15, 16, die mit den Eingängen des OR-Gatters 91 verbunden sind, führen nun alle jeweils den Wert 0, so dass das Fehlersignal f gleich 0 ist, so dass kein Fehler angezeigt wird. Man bemerkt, dass auch alle Komponenten S1, S2, S3 und S4 des Syndroms gleich 0 sind, da in den XOR-Gattern 6, 7 und 8 jeweils 0 XOR 0 = 0 und in dem XOR-Gatter 16 1 XOR 1 = 0 gebildet wird.

In einem zweiten Fall wird von der zu testenden und zu diagnostizierenden Schaltung zum zeitpunkt t der fehlerhafte Wert A1 =1, A2= 1, A3= 0, A4= 1, A5= 0, A6'= 1, A7= 0, A8 = 1 ausgegeben. Anstelle des korrekten Wertes A6 = 0 wird jetzt also fehlerhaft A6' = 1 ausgegeben. Alle anderen Werte sollen gegenüber dem ersten Zeitpunkt nicht verändert sein. Am Ausgang des XOR-Gatters 4 wird der Wert E6' XOR E7 = 1 XOR 0 = 1 gebildet, der am ersten Eingang des XOR-Gatters 14 anliegt. Am zweiten Eingang des XOR-Gatters 14 liegt nun der vom externen Tester bereitgestellte Wert v4 = 0 an. Somit wird am Ausgang des XOR-Gatters 14 der Wert 1 XOR 0 = 1 erzeugt, der in den dritten Eingang des OR-Gatters 91 geführt wird, so dass das Fehlersignal f den Wert 1 annimmt. Der Ausgang des XOR-Gatters 14 führt den Wert 1 und leitet diesen Wert an die jeweils zweiten Eingänge der XOR-Gatter 7 und 8. An deren jeweils ersten Eingängen liegen die Werte 0 an. Dadurch führen die Syndrom-Ausgänge S2 und S3 des Kompaktors $K_1$ nun jeweils den Wert 1. Das Fehlersignal f= 1 zeigt einen Fehler an und die Werte der Komponenten des Syndromes S1, S2, S3, S4 können nun zur Fehlerermittlung ausgewertet werden. Im betrachteten Kompaktor K_1 wird ein verkürzter Hammingkode verwendet, also gibt der Vektor (S1 S2 S3 S4) =( 0 1 1 0 ) in binärer Darstellung unmittelbar an, dass der Eingang E6 des Kompaktors $K_1$ und damit der Ausgang A6 der zu testenden und zu diagnostizierenden Schaltung fehlerhaft war. Die Eigenschaften dieses Kodes sind dem Fachmann bekannt.

Die Erfindung lässt es dabei zu, in einem ersten Schritt, dem Testing bzw. dem Testen, zahlreiche Schaltungen daraufhin zu überprüfen, ob diese während des Tests überhaupt einen Fehler zeigen. Dazu genügt es, den Fehlerausgang f zu überwachen. Die fehlerfreien Schaltungen können gleich verwendet werden. Bei den beim Testen als fehlerhaft erkannten Schaltungen wendet man dann die oben genannten Diagnoseschritte an, indem man die sich ergebenden Syndrome auswertet. Insofern kann also zwischen einem Testen und einem Diagnostizieren unterschieden werden, obwohl beide Male dieselbe Schaltung verifiziert wird.

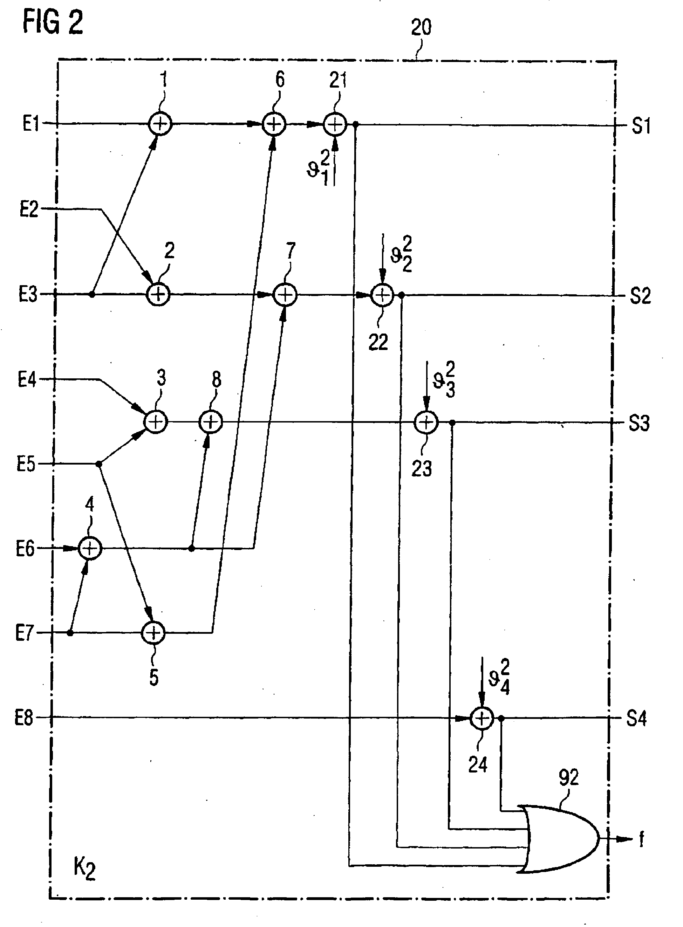

Fig. 2 zeigt eine weitere erfindungsgemäße Kompaktorschaltung $K_2$ 20 . Der Einfachheit halber wird für diese die Bezeichnung K und das Bezugszeichen 20 verwendet. Als fehlerkorrigierenden Kode wird der selbe verkürzte Hammingkode mit der durch Gleichung (1) beschriebenen Kontrollmatrix verwendet, wie für den Kompaktor $K_1$ 10 in Fig. 1. Die Kompaktorschaltung K hat M = 8 Testdaten-Eingänge E1, E2, ... , E8, die weiteren k = 4 Vergleichs-Eingänge $v_1^2, \cdots, v_4^2$ die m = 4 Syndrom-Ausgänge S1, S2, S3, S4 und den Fehlersignal-Ausgang f. Die Vergleichs-Eingänge $v_1^2, \cdots, v_4^2$ werden der Einfachheit halber im Folgenden mit v1, ..., v4 bezeichnet. Die Ausgänge A1, A2, ... , A8 der zu testenden und zu diagnostizierenden Schaltung, die in Fig. 2 nicht eingezeichnet ist, sind mit den entsprechenden Testdaten-Eingängen E1, E2, ... , E8 der Kompaktorschaltung K 20 verbunden.

Die Werte der Syndromausgänge S1,S2,S3,S4 sind durch die Gleichung

$$\begin{pmatrix} S1 \\ S2 \\ S3 \\ S4 \end{pmatrix} = H \begin{pmatrix} E1 \\ E2 \\ E3 \\ E4 \\ E5 \\ E6 \\ E7 \\ E8 \end{pmatrix} \oplus \begin{pmatrix} v_1^2 \\ v_2^2 \\ v_3^2 \\ v_4^2 \end{pmatrix}$$

festgelegt.

Der Fehlerausgang ist durch die Gleichung

$$f = (E1 \oplus E3 \oplus E5 \oplus E7 \oplus v_1^2) \vee (E2 \oplus E3 \oplus E6 \oplus E7 \oplus v_2^2)$$
$$\vee (E4 \oplus E5 \oplus E6 \oplus E7 \oplus v_3^2) \vee (E8 \oplus v_4^2)$$

bestimmt. Für die Komponenten der Signaturen erhält man unmittelbar aus der vorhergehenden Gleichung

$$S1 = E1 \oplus E3 \oplus E5 \oplus E7 \oplus v_1^2$$

$$S2 = E2 \oplus E3 \oplus E6 \oplus E7 \oplus v_2^2$$

$$S3 = E4 \oplus E5 \oplus E6 \oplus E7 \oplus v_3^2$$

$$S4 = E8 \oplus v_4^2$$

Das XOR-Symbol $\oplus$ wird nachfolgend der Einfachheit halber mit "XOR" bezeichnet.

Die k= 4 binären, vom Tester bereitgestellten Vergleichswerte v1, ... ,v4 sind für die korrekten Werte E1, ... , E8 durch v1 = E1 XOR E3 XOR E5 XOR E7,

$$v2 = E2 \; XOR \; E3 \; XOR \; E6 \; XOR \; E7,$$

$$v3 = E4 \; XOR \; E5 \; XOR \; E6 \; XOR \; E7,$$

$$v4 = E8$$

definiert.

Die Schaltung von Fig. 2 soll nun noch im Einzelnen beschrieben werden. Die Gatter in Fig. 2, die den Gattern in Fig. 1 funktionell entsprechen, sind in Fig. 2 zum besseren Verständnis mit den gleichen Bezugsziffern bezeichnet.

Der Eingang E1 ist mit dem ersten Eingang des XOR-Gatters 1 verbunden, dessen zweiter Eingang mit dem Eingang E3 verbunden ist. Der Eingang E2 ist mit dem ersten Eingang des XOR-Gatters 2 verbunden, dessen zweiter Eingang mit dem Eingang E3 verbunden ist. Der Eingang E4 ist mit dem ersten Eingang des XOR-Gatters 3 verbunden, dessen zweiter Eingang mit dem Eingang E5 verbunden ist, der gleichzeitig ebenfalls mit dem ersten Eingang des XOR-Gatters 5 verbunden ist und dessen zweiter Eingang mit dem Eingang E7 verbunden ist, der gleichzeitig mit dem zweiten Eingang des XOR-Gatters 5 verbunden ist, in dessen ersten Eingang der Eingang E6 geführt ist. Der Ausgang des XOR-Gatters 1 ist mit dem ersten Eingang des XOR-Gatters 6 verbunden, dessen zweiter Eingang mit dem Ausgang des XOR-Gatters 5 verbunden ist. Der Ausgang des XOR-Gatters 2 ist mit dem ersten Eingang des XOR-Gatters 7 verbunden, dessen zweiter Eingang mit dem Ausgang des XOR-Gatters 4 verbunden ist. Der Ausgang des XOR-Gatters 3 ist mit dem ersten Eingang des XOR-Gatters 8 verbunden, dessen zweiter Eingang mit dem Ausgang des XOR-Gatters 4 verbunden ist. Der Ausgang des XOR-Gatters 6 ist mit dem ersten Eingang eines XOR-Gatters 21 verbunden, an dessen zweitem Eingang das vom Tester bereitgestellte binäre Signal v1 anliegt. Der Ausgang des XOR-Gatters 21, der die erste Komponente S1 des Syndromes führt, ist mit dem vierten Eingang des OR-Gatters 92 verbunden i. Der Ausgang des XOR-Gatters 7 ist mit dem ersten Eingang des XOR-Gatters 22 verbunden, an dessen zweitem Eingang das vom Tester bereitgestellte binäre Signal v2 anliegt. Der Ausgang des XOR-Gatters 23, der die zweite Komponente S2 des Syndroms führt, ist mit dem dritten Eingang des OR-Gatters 92 verbunden. Der Ausgang des XOR-Gatters 8 ist mit dem ersten Eingang des XOR-Gatters 23 verbunden, an dessen zweitem Eingang das vom Tester bereitgestellte binäre Signal v3 anliegt. Der Ausgang des XOR-Gatters 23, der die dritte Komponente S3 des Syndromes führt, mit dem zweiten Eingang des OR-Gatters 92 verbunden.

Der Eingang E8 ist mit dem ersten Eingang des XOR-Gatters 24 verbunden, an dessen zweitem Eingang das vom Tester bereitgestellte binäre Signal v4 anliegt. Der Ausgang des XOR-Gatters 24, der die vierte Komponente S4 des Syndromes führt, mit dem ersten Eingang des OR-Gatters 92 verbunden. Der Ausgang des OR-Gatters 92 führt das Fehlersignal f.

Man bemerkt, dass k = m = 4 gilt, also dass die Wortbreite bzw. die Anzahl der vom Tester bereitgestellten Vergleichssignale gleich der Anzahl der Komponenten des Syndroms bzw. der Ausgänge des Kompaktors 20 ist. Man sagt hierzu auch gelegentlich verkürzt, die Anzahl der Syndrome sei gleich 4. Die Teilmenge der Leitungen des Kompaktors K die im fehlerfreien Fall jeweils den Wert 0 führen und die mit den Eingängen des OR-Gatters verknüpft sind, werden hier durch die Ausgangsleitungen der XOR-Gatter 21, 22, 23 und 24 gebildet.

Die Anzahl der vom Tester bereitgestellten Vergleichssignale ist im Falle von Fig. 2 kleiner als im Fall von Fig. 1. Es kann also ein einfacherer Tester verwendet werden. Man nimmt aber in Kauf, dass im vergleich mehr Fehler unerkannt bleiben.

Die Funktionsweise des Kompaktors K 20 zum Test und zur Diagnose soll nun für die gleichen Daten wie für den Kompaktor K erläutert werden, um den Zusammenhang zwischen der Anzahl der vom Tester bereitgestellten Vergleichssignale - hier kleiner als in Fig. 1 gewählt - und der Wahrscheinlichkeit, dass ein Fehler nicht als solcher erkannt wird, zu veranschaulichen. Das XOR-Symbol $\oplus$ wird nachfolgend der Einfachheit halber mit "XOR" bezeichnet.

Zu einem betrachteten Zeitpunkt t sei die korrekte Ausgabe der zu testenden und zu diagnostizierenden Schaltung als Antwort auf eine entsprechende Testeingabe wieder mit A1 = 1, A2= 1, A3 = 0, A4 = 1, A5 = 0, A6 = 0, A7 = 0, A8 = 1 angenommen. Die Ausgänge Ai der Schaltung S sind mit den Eingängen Ei des Kompaktors 20 für i = 1, ... , 8 verbunden, so dass an den Eingängen des Kompaktors die Werte E1 = 1, E2 = 1, E3= 0, E4= 1, E5 = 0, E6 = 0, E7 = 0, E8 = 1 anliegen. Am Ausgang des XOR-Gatters 1 wird der Wert E1 XOR E3 = 1 XOR 0 = 1 gebildet. Am Ausgang des XOR-Gatters 2 wird der Wert E2 XOR E3 = 1 XOR 0 = 1 gebildet. Am Ausgang des XOR-Gatters 3 wird der Wert E4 XOR E5 = 1 XOR 0 = 1 gebildet. Am Ausgang des XOR-Gatters 4 wird der Wert E6 XOR E7 = 0 XOR 0 = 0 gebildet. Am Ausgang des XOR-Gatters 5 wird der Wert E5 XOR E7 = 0 XOR 0 = 0 gebildet. Am Ausgang des XOR-Gatters 6 wird der Wert 1 XOR 0 = 1 gebildet, der am ersten Eingang des XOR-Gatters 21 anliegt. Um am Ausgang des XOR-Gatters 21 den Wert 0 zu erzeugen, muss am zweiten Eingang dieses Gatters der binäre Wert v1 = 1 anliegen, der vom Tester bereitgestellt wird.

Am Ausgang des XOR-Gatters 7 wird der Wert 1 XOR 0 = 1 gebildet, der am ersten Eingang des XOR-Gatters 22 anliegt. Um am Ausgang des XOR-Gatters 22 den Wert 0 zu erzeugen, muss am zweiten Eingang dieses Gatters der binäre Wert v2 = 1 anliegen, der vom Tester bereitgestellt wird.

Am Ausgang des XOR-Gatters 8 wird der Wert 1 XOR 0= 1 gebildet, der am ersten Eingang des XOR-Gatters 23 anliegt. Um am Ausgang des XOR-Gatters 23 den Wert 0 zu erzeugen, muss am zweiten Eingang dieses Gatters der binäre Wert v3 = 1 anliegen, der vom Tester bereitgestellt wird.

Am Eingang des XOR-Gatters 24 liegt der Wert E8 = 1 an. Um am Ausgang des XOR-Gatters 24 den Wert 0 zu erzeugen, muss an seinem zweiten Eingang der binäre Wert v4 = 1 anliegen, der vom Tester bereitgestellt wird.

Man bemerkt, dass nun alle Komponenten S1, S2, S3 und S4 des Syndromes gleich 0 sind.

Wir nehmen nun wie im Falle des Kompaktors $K_1$ an, dass von der zu testenden und zu diagnostizierenden Schaltung zum Zeitpunkt t der fehlerhafte Wert A1 = 1, A2 = 1, A3 = 0, A4 = 1, A5 = 0, A6' = 1, A7 = 0, A8 = 1 ausgegeben wird. Anstelle des korrekten Wertes A6 = 0 wird jetzt fehlerhaft A6' = 1 ausgegeben. Alle anderen Werte sollen nicht verändert sein. Die von den XOR-Gattern 1, 2, 3, 5, 6, 21 und 24 ausgegebenen Werte bleiben unverändert gleich 1, 1, 1, 0, 0 und 0. Die von den XOR-Gattern 4, 7 , 8, 22, und 23 ausgegebenen Werte sind nun 1, 0, 0, 1 und 1, und das Fehlersignal f = 1 zeigt einen Fehler an. Werden nun die Ausgänge des Kompaktors K ausgewertet, so gibt der Vektor (S1 S2 S3 S4) =( 0 1 1 0 ) in binärer Darstellung unmittelbar an, dass der Eingang E6 des Kompaktors K und damit der Ausgang A6 der zu testenden und zu diagnostizierenden Schaltung fehlerhaft war.

Der Hamming-Kode ist nämlich in der Verwendung im erfindungsgemäßen Kompaktor so, dass dessen Ausgänge in binärer Form unmittelbar angeben, bei welchem Eingang ein Fehler aufgetreten ist. Hier gibt er also, von rechts nach links, als Binärzahl 0 1 1 0 (= 0 + 4 + 2 + 0 = 6) die dem Eingang entsprechende Ordnungszahl 6 aus.

Sind in der Schaltung von Fig. 1 beispielsweise die Eingangswerte der Eingänge E1, E6 und E7 des Kompaktors 10 gleichzeitig fehlerhaft, so sind der Ausgang des XOR-Gatters 1 und der Ausgang des XOR-Gatters 5 fehlerhaft.

Die fehlerhaften Ausgänge dieser XOR-Gatter werden dann durch die vom Tester bereitgestellten Vergleichswerte v1 und v5 bei Eingabe in die XOR-Gatter 11 und 15 nicht kompensiert, so dass am Ausgang dieser Gatter der Wert 1 auftritt und das OR-Gatter 91 einen Fehler anzeigt.

Sind hingegen die Eingangswerte der gleichen Eingänge E1, E6 und E7 des Kompaktors K 20 in Fig. 2 gleichzeitig fehlerhaft, so kompensieren sich diese drei Fehler der Eingangswerte in den XOR-Gattern 4 und 6. Die dann an den jeweils ersten Eingängen der XOR-Gatter 21, 22, 23 und 24 anliegenden Werte erscheinen dann alle korrekt. Die XOR-Verknüpfung mit den vom Tester bereitgestellten Vergleichswerten v1, v2, v3, v4, die an den jeweils zweiten Eingängen dieser XOR-Gatter anliegen, ergibt jeweils den Wert 0 an den Ausgängen dieser XOR-Gatter 21, 22, 23 und 24. Da die Ausgänge der XOR-Gatter 21, 22, 23 und 24 in die Eingänge des ODER-Gatters 92 und alle diese Ausgänge den Wert 0 tragen, gilt f = 0, und es wird kein Fehlersignal ausgegeben, obwohl ein Fehler vorliegt.

Man sieht am letzten Beispiel, dass manche sog. "Mehrfachfehler" nicht als fehlerhaft erkannt werden können, wenn nur vier Vergleichssignale vom Tester bereitgestellt werden und nicht sechs Vergleichssignale wie in Fig. 1. Der Aufwand für die Realisierung des Tests ist dann aber entsprechend kleiner. In der Praxis ist die Wahrscheinlichkeit für das Nichterkennen von Mehrfachfehlern relativ gering. Die damit verbundene Einschränkung der Fehlererkennung kann erfindungsgemäß in Kauf genommen werden.

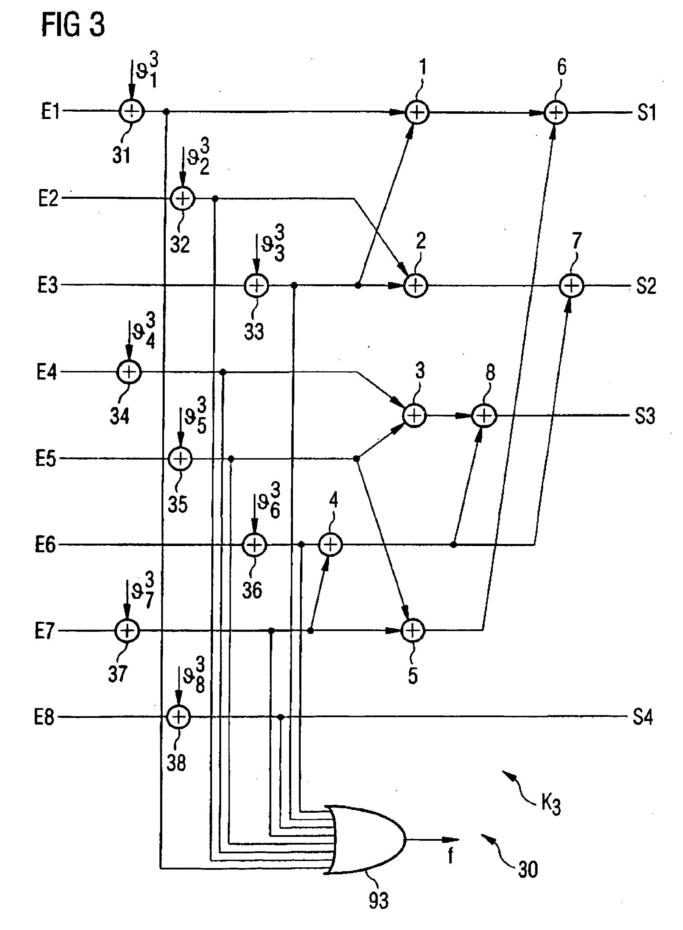

Fig. 3 zeigt eine weitere erfindungsgemäße Kompaktorschaltung $K_3$ 30. Der Einfachheit halber wird die Kompaktorschaltung $K_3$ 30 im folgenden kurz als Kompaktorschaltung K 30 bezeichnet. Als fehlerkorrigierenden Kode ist der gleiche verkürzte Hammingkode mit der gleichen Kontrollmatrix verwendet worden, wie für den Kompaktor $K_1$ 10 in Fig. 1 und für den Kompaktor $K_2$ von Fig. 2. Die Kompaktorschaltung K 30 hat M = 8 Testdaten-Eingänge E1, E2, ... , E8, k = M = 8 weitere Vergleichs-Eingänge $v_1^2, \cdots, v_8^2$, m = 4 Syndrom-Ausgänge S1, S2, S3, S4 und einen Fehlersignal-Ausgang f. Die Vergleichs-Eingänge $v_1^2, \cdots, v_8^2$ sind im folgenden kurz mit v1, v2, ..., v8 bezeichnet. Die Ausgänge A1, A2, ... , A8 der hier nicht gezeigten zu testenden und zu diagnostizierenden Schaltung sind mit den entsprechenden Testdaten-Eingängen E1, E2, ... , E8 der Kompaktorschaltung K 30 verbunden.

Das für die XOR-Verknüpfung verwendete Symbol ⊕ wird nachfolgend der Einfachheit halber mit "XOR" bezeichnet.

Für die Komponenten des Syndrom bzw. für die Syndrome gilt nun

$$S1 = E1 \; XOR \; E3 \; XOR \; E5 \; XOR \; E7 \; XOR \; v1 \; XOR \; v3 \; XOR \; v5 \; XOR \; v7$$

$$S2 = E2 \; XOR \; E3 \; XOR \; E6 \; XOR \; E7 \; XOR \; v2 \; XOR \; v3 \; XOR \; v6 \; XOR \; v7$$

$$S3 = E4 \; XOR \; E5 \; XOR \; E6 \; XOR \; E7 \; XOR \; v4 \; XOR \; v5 \; XOR \; v6 \; XOR \; v7$$

$$S4 = E8 \; XOR \; v8$$

Die k= 8 binären, vom Tester bereitgestellten vergleichswerte v1, ... ,v8 sind vor dem Durchführen der Evaluation der Schaltung so festgelegt worden, dass bei einem Vorliegen der korrekten Werte an den Eingängen E1, ... , E8 für i = 1, ... ,8 kein Fehler am Syndromausgang S1 bis S4 und am Fehlersignal-Ausgang f angezeigt wird.

Der Fehlerausgang ist durch die Gleichung

$$f = (E1 \text{ XOR } v1) \lor (E2 \text{ XOR } v2) \lor (E3 \text{ XOR } v3) \lor (E4 \text{ XOR } v4) \lor (E5 \text{ XOR } v5) \lor (E6 \text{ XOR } v6) \lor (E7 \text{ XOR } v7) \lor (E8 \text{ XOR } v8)$$

bestimmt. Dabei steht das Symbol "V" hier für eine logische Oder-Verknüpfung "OR".

Die Schaltung von Fig. 3 soll nun noch im Einzelnen beschrieben werden. Die Gatter in Fig. 3, die den Gattern in den Figuren Fig. 1 und Fig. 2 funktionell entsprechen, sind in Fig. 3 zum besseren Verständnis mit den gleichen Bezugsziffern markiert worden.

Fig. 3 veranschaulicht dabei, dass die vom Tester bereitgestellten Vergleichssignale v1, ..., v8 auch unmittelbar an den Kompaktoreingängen mit den dort anliegenden Eingangssignalen E1, ..., E8 verknüpft werden können, wenn man die der Erfindung zugrunde liegenden Gedanken anwendet.

Der Eingang E1 ist mit dem ersten Eingang des XOR-Gatters 31 verbunden, an dessen zweitem Eingang das vom Tester bereitgestellte Vergleichssignal v1 anliegt und dessen Ausgang in den ersten Eingang der XOR-Gatters 1 und in den achten Eingang des OR-Gatters 93 geführt ist. Der Eingang E2 ist mit dem ersten Eingang des XOR-Gatters 32 verbunden, an dessen zweitem Eingang das vom Tester bereitgestellte Vergleichssignal v2 anliegt und dessen Ausgang in den ersten Eingang der XOR-Gatters 2 und in den siebenten Eingang des OR-Gatters 93 geführt ist. Der Eingang E3 ist mit dem ersten Eingang des XOR-Gatters 33 verbunden, an dessen zweitem Eingang das vom Tester bereitgestellte Vergleichssignal v3 anliegt und dessen Ausgang in den zweiten Eingang der XOR-Gatters 1, den zweiten Eingang des XOR-Gatters 2 und in den sechsten Eingang des OR-Gatters 93 geführt ist. Der Eingang E4 ist mit dem ersten Eingang des XOR-Gatters 34 verbunden, an dessen zweitem Eingang das vom Tester bereitgestellte Vergleichssignal v4 anliegt und dessen Ausgang in den ersten Eingang der XOR-Gatters 3 und in den fünften Eingang des OR-Gatters 93 geführt ist. Der Eingang E5 ist mit dem ersten Eingang des XOR-Gatters 35 verbunden, an dessen zweitem Eingang das vom Tester bereitgestellte Vergleichssignal v5 anliegt und dessen Ausgang in den zweiten Eingang der XOR-Gatters 3, in den ersten Eingang des XOR-Gatters 5 und in den vierten Eingang des OR-Gatters 93 geführt ist. Der Eingang E6 ist mit dem ersten Eingang des XOR-Gatters 36 verbunden, an dessen zweitem Eingang das vom Tester bereitgestellte Vergleichssignal v6 anliegt und dessen Ausgang in den ersten Eingang des XOR-Gatters 4 und in den dritten Eingang des OR-Gatters 93 geführt ist. Der Eingang E7 ist mit dem ersten Eingang des XOR-Gatters 37 verbunden, an dessen zweitem Eingang das vom Tester bereitgestellte Vergleichssignal v7 anliegt und dessen Ausgang in den zweiten Eingang der XOR-Gatters 4, in den zweiten Eingang des XOR-Gatters 5 und in den zweiten Eingang des OR-Gatters 93 geführt ist. Der Eingang E8 ist mit dem ersten Eingang des XOR-Gatters 38 verbunden, an dessen zweitem Eingang das vom Tester bereitgestellte Vergleichssignal v8 anliegt, dessen Ausgang mit dem das die vierte Komponente S4 des Syndroms tragenden Ausgang des Kompaktors verbunden ist und in den ersten Eingang des OR-Gatters 93 geführt ist.

Die Teilmenge derjenigen Leitungen, die im fehlerfreien Fall den Wert 0 führen und die mit den Eingängen des OR-Gatters 93 verknüpft sind, werden in Fig. 3 durch die Ausgangsleitungen der XOR-Gatter 31, 32, 33, 34, 35, 36, 37 und 38 gebildet.

Der Ausgang des XOR-Gatters 1 ist mit dem ersten Eingang des XOR-Gatters 6 verbunden, dessen zweiter Eingang mit dem Ausgang des XOR-Gatters 5 verbunden ist. Der Ausgang des XOR-Gatters 2 ist mit dem ersten Eingang des XOR-Gatters 7 verbunden, dessen zweiter Eingang mit dem Ausgang des XOR-Gatters 4 verbunden ist. Der Ausgang des XOR-Gatters 3 ist mit dem ersten Eingang des XOR-Gatters 8 verbunden, dessen zweiter Eingang mit dem Ausgang des XOR-Gatters 4 verbunden ist. Die Ausgänge der XOR-Gatter 6, 7 und 8 sind mit den die Komponenten S1, S2 und S3 tragenden Ausgängen des Kompaktors verbunden. Der Ausgang des OR-Gatters 93 führt das Fehlersignal f.

Man bemerkt, dass k = M = 8 gilt. Mit dieser Anordnung ist gewährleistet, dass beliebige Fehler am Ausgang der zu testenden und zu diagnostizierenden Schaltung erkannt werden können, wobei dies mit einem gegenüber Fig. 1 und Fig. 2 aufwendigeren Tester mit 8 Vergleichssignalen erkauft werden muss. Jedem Ausgang der Schaltung S muss nämlich - anders als in Fig.1 und Fig. 2 - ein Vergleichswert vom Tester gegenübergestellt werden, was gerade bei den eingangs genannten Schaltungen einen hohen Aufwand bedeuten kann.

Die Funktionsweise der Kompaktors K 30 zum Test und zur Diagnose soll nun für die gleichen Daten wie für den Kompaktor $K_1$ erläutert werden.

Zu einem betrachteten Zeitpunkt t sei die korrekte Ausgabe der zu testenden und zu diagnostizierenden Schaltung als Antwort auf eine entsprechende Testeingabe wieder mit A1 =1, A2= 1, A3= 0, A4= 1, A5 = 0, A6= 0, A7 = 0, A8 = 1 angenommen. Die Ausgänge Ai sind mit den Eingängen Ei für i= 1, ... , 8 verbunden, so dass an den Eingängen des Kompaktors die Werte E1 =1, E2= 1, E3= 0, E4= 1, E5 = 0, E6= 0, E7 = 0, E8 = 1 anliegen. Wegen Ei = vi für i= 1, ... , 8 gilt nun

v1 = 1, v2 = 1, v3 = 0, v4 = 1, v5 = 0 , v6 = 0, v7 = 0, v8 = 1 und an den Ausgängen der XOR-Gatter 31, 32,

33, 34, 35, 36, 37, 38 wird, ebenso wie an den Ausgängen aller anderen XOR-Gatter, der Wert 0 ausgegeben. Das Fehlersignal und auch die Komponenten S1, S2, S3 und S4 des Syndromes sind 0.

Wir nehmen nun wie im Falle des Kompaktors $K_1$ an, dass von der zu testenden und zu diagnostizierenden Schaltung zum Zeitpunkt t der fehlerhafte Wert A1 = 1, A2 = 1, A3 = 0, A4 = 1, A5 = 0, A6' = 1, A7 = 0, A8 = 1 ausgegeben wird. Anstelle des korrekten Wertes A6 = 0 wird jetzt also fehlerhaft A6' = 1 ausgegeben. Alle anderen Werte sollen nicht verändert sein. Da nun am ersten Eingang des XOR-Gatters 36 der Wert A6' = 1 und am zweiten Eingang dieses Gatters der vom Tester bereitgestellte Wert v6 = 0 anliegen, gibt das XOR-Gatter 36 den Wert 1 aus, während die KOR-Gatter 31, 32, 33, 34, 35, 37 und 38 jeweils den Wert 0 ausgeben. Da am dritten Eingang des OR-Gatters 93 nun der Wert 1 anliegt, gibt dieses Gatter nun den Fehlerwert f = 1 aus. Da der Ausgang des XOR-Gatters 36 über die XOR-Gatter 4 und 8 mit dem die Komponente S3 führenden Ausgang des Kompaktors und über die XOR-Gatter 4 und 7 mit dem die Komponente S2 führenden Ausgang des Kompaktors verbunden ist und mit den die Komponenten S1 und S4 führenden Ausgängen nicht verbunden ist, ist das Fehlersyndrom gleich (S1, S2, S3, S4) = (0, 1, 1, 0), und es zeigt binär (= dezimal "6")kodiert unmittelbar an, dass das Signal am Eingang E6 fehlerhaft ist, an den der Ausgang A6 der zu testenden und zu diagnostizierenden Schaltung angeschlossen ist.

Man bemerkt, dass in dem Fall, wenn für jeden Eingang des Kompaktors E1, ... , E8 vom Tester ein Vergleichswert v1, ... , v8 bereitgestellt wird, jeder mögliche Fehler am Fehlersignal f angezeigt werden kann, auch Fehler, die von den obenstehend gezeigten Kompaktoren nicht angezeigt werden können. Anhand des Fehlersyndroms des betrachteten Kodes, hier des betrachteten verkürzten Hammingkodes, können die Fehler lokalisiert werden, die durch den Kode korrigiert werden können. Für einen Hammingkode sind das bekanntermaßen 1-Bit Fehler. In völlig analoger Weise kann man auch andere fehlerkorrigierende Kodes anwenden, indem man einfach die für Fig. 1, Fig. 2 und Fig. 3 verwendete H-Matrix H durch die H-Matrix des gewählten Kodes ersetzt. Als Beispiele bieten sich die dem Fachmann gut bekannten Fire-Kodes oder BCH-Kodes an. Die Anwendung eines speziellen linearen fehlerkorrigierenden Kodes ist ebenfalls Gegenstand der Erfindung. Derartige Kodes, wie sie hier eingesetzt werden können, sind z. B. in der oben genannten Referenz "Peterson" beschrieben.

Man bemerkt, dass man die Kompensation der Testantworten der zu testenden oder zu diagnostizierenden Schaltung durch die vom Tester bereitgestellten Werte v auf den Wert "0" an verschiedenen Stellen des Kompaktors vornehmen kann. Werden die Eingangsleitungen E des Kompaktors kompensiert, so benötigt man eine große Wortbreite M der vom Tester bereitgestellten Werte v. Werden dagegen die Werte am Ausgang S kompensiert, so benötigt man dagegen nur eine Wortbreite m für den Vektor v, wobei m < M ist, nimmt jedoch in Kauf, dass bestimmte Arten von Fehlern nicht detektierbar sind. Eine Kompensation auch auf internen Leitungen des Kompaktors K wie in Fig. 1 beschrieben ist ebenfalls möglich, dadurch nimmt man einen Kompromiss zwischen dem Aufwand durch das Bereitstellen der Werte v und den nicht detektierbaren Fehlern in Kauf.

Der Aufwand, der durch die Wortbreite von v gegeben ist, bestimmt damit die Genauigkeit bzw. Wahrscheinlichkeit, mit der ein eventueller Fehler in den Testantworten der Schaltung S am Ausgang f erkannt wird. Es ist daher beim Entwurf des Kompaktors abzuwägen, welchen Aufwand und welche Fehlererkennungswahrscheinlichkeit man investieren möchte. Daraus ergibt sich sowohl die Anzahl als auch die Anordnung der Kompensations-XOR-Gatter, in die die Werte v eingegeben werden.

Zum Entwurf des Kompaktors K geht man nach dieser Entscheidung wie folgt vor, um die Kompensations-XOR-Gatter anzuordnen.

Als erstes werden die H-Matrix-XOR-Gatter entsprechend der H-Matrix gesetzt. Zur Bildung des i-ten Syndromausganges Si, i = 1,...,m, wird die i-te Zeile der H-Matrix betrachtet. Die Positionen der i-ten Zeile der H-Matrix H, die den Wert 1 annehmen, bestimmen die Testdateneingänge der Kompaktors, die durch die H-Matrix-XOR-Gatter zum Syndromausgang Si verknüpft werden, wenn die i-te Zeile der H-Matrix wenigstens 2 Einsen enthält.

Enthält die i-te Zeile der H-Matrix nur eine Eins, etwa an der j-ten Position, dann ist der Testdateneingang Ej mit dem Syndromausgang Si zu verbinden.

Für die Kompaktoren, die in Fig.1, Fig. 2 und Fig. 3 dargestellt sind, ist die erste Zeile der H-Matrix 10101010. Da die erste, dritte, fünfte und siebente Position in dieser Zeile gleich 1 sind, werden die Testdateneingänge E1, E3, E5 und E7 durch die H-Matrix-XOR-Gatter 1, 5 und 6 zum Syndromausgang S1 verknüpft.

Die zweite Zeile der H-Matrix ist 01100110. Da die zweite, dritte, sechste und siebente Position dieser zeile gleich 1 sind, werden die Testdateneingänge E2, E3, E6 und E7 durch die H-Matrix-XOR-Gatter 2, 4 und 7 zum Syndromausgang S2 verknüpft.

Die dritte Zeile der H-Matrix ist 00011110. Da die vierte, fünfte, sechste und siebente Position dieser Zeile gleich eins sind, werden die Testdateneingänge E4, E5, E6 und E7 durch die H-Matrix-XOR-Gatter 3,4 und 8 zum Syndromausgang S3 verknüpft.

Die vierte Zeile der H-Matrix ist 00000001. Da hier nur die achte Position dieser Zeile gleich 1 ist wird nur der Testdateneingang E8 zur Bildung des Syndromausganges S4 verwendet.

Als erstes werden die H-Matrix-Gatter entsprechend der Elemente der H-Matrix gesetzt. Dort wo in der H-Matrix eine "1" ist, muss ein H-Matrix-Gatter angeordnet werden. Die Anzahl der Zeilen der H-Matrix entspricht der Anzahl der Syndromausgänge S, die Anzahl der Spalten entspricht der Anzahl der Eingänge E. Zwischen den Syndromausgängen, der H-Matrix und den Eingängen E besteht eine Beziehung nach der Vektorgleichung A = H * E.

Man kann nur an allen Ausgängen S jeweils ein Kompensations-XOR-Gatter anordnen, aber dann kann man nicht alle Fehler erkennen. Auch an allen Eingängen E kann man die Kompensations-XOR-Gatter anordnen. Dann ist es aber sehr aufwendig. Bei der erfindungsgemäßen Anwendung eines Kompaktors hat man in diesem Fall den Vorteil, dass man nur die Fehlerbits entsprechend der Anzahl der Ausgänge des Kompaktors abspeichern muss und nicht alle Ausgänge A der Schaltung S. Zur Auswertung der Fehler muss man nur die Syndrombits des Syndroms S ansehen und nicht alle Bits an den Eingängen E bzw. an den Ausgängen A.

Man kann auch dazwischen variieren, wenn man einen guten Mittelwert zwischen Aufwand und Fehlererkennungswahrscheinlichkeit erzielen möchte.

Man soll die Kompensations-XOR-Gatter so anbringen, dass die XOR-Gatter im Fehlerfreien Fall die Syndromwerte "0 .... 0" erzeugen. Dazu kann man entweder deren Position variieren nach "trial and error" oder man kann auch wie folgt vorgehen.

1. Man legt einen Schnitt durch die Verdrahtung des Kompaktors ohne Kompensations-XOR-Gatter, und zwar an irgendeiner Stelle,

2. an allen Schnittstellen wird ein Kompensations-XOR-Gatter angebracht, so dass ein Eingang des jeweiligen Kompensations-XOR-Gatter im Signalfluß zum Eingang E des Kompaktors hin liegt und dass der Ausgang des jeweiligen Kompensations-XOR-Gatter im Signalfluß zum Ausgang S des Kompaktors hin liegt. Der andere Eingang des XOR-Gatters wird mit einem Kompensationssignal v beaufschlagt, wobei man die richtigen Kompensationssignale durch vorherige Simulation ermittelt. Dies ist kein großer Aufwand, denn alle zum Testen bzw. Diagnostizieren benötigten Signale werden vorab durch Simulation ermittelt.

In Fig. 1 ist dieser Schnitt durch die folgenden Leitungen gelegt: Ausgangsleitung des XOR-Gatters 1, Ausgangsleitung des XOR-Gatters 2, Ausgangsleitung des XOR-Gatters 3, Ausgangsleitung des XOR-Gatters 4, Ausgangsleitung des XOR-Gatters 5, Leitung, die mit dem Eingang E8 verbunden ist.

Die entsprechenden Kompensations-XOR-Gatter sind dann die XOR-Gatter 11,12,13,14,15 und 16.

In Fig. 2 ist dieser Schnitt durch die folgenden Leitungen gelegt: Ausgangsleitung des XOR-Gatters 6, Ausgangsleitung des XOR-Gatters 7, Ausgangsleitung des XOR-Gatters 8, Leitung, die mit dem Eingang E8 verbunden ist.

Die entsprechenden Kompensations-XOR-Gatter sind dann die XOR-Gatter 21, 22, 23 und 24.

In Fig. 3 ist dieser Schnitt durch die Leitungen gelegt, die mit den Eingängen E1, E2, E3, E4, E5, E6, E7 und E8 verbunden sind. Die entsprechenden Kompensations-XOR-Gatter sind dann die XOR-Gatter 31,32,33,34,35, 36, 37 und 38.

Beim Testen der Schaltung S wird dabei in einem Testschritt nur überprüft, ob für jeden Einzeltest, d.h. Anlegen eines Testsignals und Überprüfen anhand des zu erwartenden kompaktierten Ausgangssignals, der Wert für f gleich "0" ist. Wenn dies für alle Testschritte gilt, wird die Schaltung S als fehlerfrei betrachtet und es kann die nächste Schaltung getestet werden.

Falls dies nicht der Fall ist, also wenn f durch ein Signal "1" einen Fehler anzeigt, werden die dabei auftretenden Syndromwerte zur Diagnose des Fehlers ausgewertet. Dann kann die Fehlerursache einfach und genau bestimmt werden, indem man aufgrund der Kodeeigenschaften aus den wenigen Syndromwerten S auf diejenigen Eingangswerte E schließt, die fehlerhaft sind.

Es ergibt sich ein Geschwindigkeitsvorteil und der Testaufwand wird dadurch erheblich reduziert, weil man zum Auswerten eines Fehlers gegenüber den Werten der Vielzahl der Schaltungsausgänge A nur die Werte der kleineren Zahl von Syndromwerten S benötigt.

In der Praxis geht man davon aus, dass für 1.000 Schaltungsausgänge im günstigsten Fall nur 10 Syndromwerte auszuwerten sind, wenn ein Hammingkode verwendet wird, der das Diagnostizieren aller Einzelfehler sicher erlaubt. Allerdings nimmt man in Kauf, dass aufgrund der durch die Kodeeigenschaften erfolgenden Kompaktierung eine Unschärfe in der Weise vorliegen kann, dass eine geringere zahl von Fehlern beim Test nicht erkannt werden kann oder bei der Diagnose nicht diagnostiziert werden können. In der Praxis ist dieser Anteil vernachlässigbar, insbesondere bei der Fehlererkennung.

Fig. 4 unterscheidet sich von Fig. 3 dadurch, dass das dort verwendete Element 93, das die Boolesche Funktion OR realisiert hat, durch die kombinatorische Schaltung SwF (Schwellenwert-Funktion) 39 ergänzt ist. Die kombinatorische Schaltung SwF gibt einen binären Wert ndF = 1 (nicht diagnostizierbarer Fehler) aus, wenn die Anzahl der Einsen an ihren Eingängen einen Schwellenwert SW überschreitet. Die den Elementen der Schaltung von Fig. 3 entsprechenden übrigen Elemente von Fig. 4 sind mit den gleichen Bezugsziffern wie in Fig. 3 bezeichnet und sie sollen nicht noch einmal beschrieben werden.

Wird, wie in Fig. 4 ein verkürzter Hammingkode verwendet, so können an den Ausgängen der Schaltung S1, S2, S3 und S4, die das Fehlersyndrom des anliegenden Fehlers ausgeben, alle Ein-Bit Fehler an den Eingängen der Schaltung richtig diagnosiziert werden, wie das schon obenstehend beschrieben worden ist.

Liegt nun ein zwei- oder mehr-Bit Fehler an den Schaltungseingängen der Schaltung von Fig. 4 vor, d.h. mehr als ein Fehler an den Eingängen E1, ..., E8, so kann ein derartiger Fehler durch einen Hammingkode nicht korrekt diagnostiziert werden, obwohl ein Syndromwert ungleich 0,0,0,0 an den Ausgängen S1, S2, S3, S4 ausgegeben wird.

Für einen Hammingkode realisiert die kombinatorische Schaltung SwF die Boolesche Funktion

$$ndf = \begin{cases} 1 \ wenn \ \sum_i E_i \oplus v_i^3 \geq 2 \\ 0 \ wenn \ \sum_i E_i \oplus v_i^3 < 2 \end{cases}$$

Man bemerkt, dass am Ausgang ndF der kombinatorischen Schaltung SwF 39 ein binärer Wert 1 ausgegeben wird, wenn nach der komponentenweisen XOR-Verknüpfung der an den Eingängen E1, ... , E8 anliegenden Werte mit den von Tester bereitgestellten Werten v2, ... , v8 mindestens zwei Einsen vorhanden sind, die an den Eingängen der Schaltung SwF 39 anliegen, und der betrachtete Hammingkode nicht ausreicht, um einen zwei- oder mehr-Bit Fehler korrekt anhand seines Syndroms zu diagnostizieren. Eine Diagnose fällt somit aus, man muss für solche sehr seltenen Fälle andere Tests verwenden. Wichtig ist dabei, dass man weiß, dass man einen Fehler nicht falsch diagnostiziert.

Die die Syndromwerte S1, S2, S3, S4 tragenden Ausgangsleitungen der Schaltung von Fig. 4 sind in ein OR-Gatter 310 geführt, das ein Fehlersignal f ausgibt, wenn ein Syndromwert ungleich 0,0,0,0 vorliegt.

Fig. 5 zeigt, dass die Ausgänge der zu testenden und/oder zu diagnostizierenden Schaltung S auch Ausgänge von Scan-Pfaden dieser Schaltung sein können. Scan-Pfade sind beim Testen dem Fachmann bekannt. Sie ermöglichen beim Testen das Ein- und Ausschieben der Testdaten.

Scan-Pfade sind beispielsweise in Abramovici,M., Breuer,M. and Friedman, A.: Digital Systems Testing and Testable Design, Computer Science Press, 1990 beschrieben.

Ausgänge A1, A2, ... , AM der Scan-Pfade Sc1, Sc2, ... ,ScM der zu testenden und/oder zu diagnostizierenden Schaltung sind mit den Eingängen E1, E2, ... , EM des Kompaktors K 50 verbunden. Der k Bit breite Vergleichsvektor V wird vom Tester 51 bereitgestellt, und vom erfindungsgemäßen Kompaktor 51 werden das Fehlersignal f und die Werte des Syndromes S1, S2, ... , Sm ausgegeben.

In Fig. 6 ist eine erste Möglichkeit beschrieben, wie ein erfindungsgemäßer Kompaktor angewendet werden kann, wenn von der zu testenden und diagnostizierenden Schaltung auch unbestimmte, sogenannte X-Werte ausgegeben werden. Solche X-Werte entstehen z.B., wenn bestimmte Bereiche der Schaltung S zu Beginn des Tests oder der Diagnose nicht initialisiert werden. Dies können Flip-Flops oder Tri-State-Komponenten sein. Diese Bereiche können zufällige Werte annehmen, die für den Test oder die Diagnose unerheblich sind. Durch dem Test vorhergehende Simulationen oder Untersuchungen kann der Zeitpunkt und der betreffende Ausgang A der Schaltung S, an dem ein solcher unbestimmter bzw. X-Wert auftritt vorhergesagt werden, jedoch nicht sein konkreter Wert. Damit dieser nicht fälschlich als Fehler angezeigt wird, wird er erfindungsgemäß maskiert oder ausgeblendet.

Die zu testenden und/oder zu diagnostizierenden Schaltung von Fig. 6 weist M Ausgänge A1, A2, ... , AM von M Scan-Pfaden S1 62, S2 63,..., SM 64 auf.

Der Ausgang A1 ist in einen ersten Eingang eines OR-Gatters 65 zur Maskierung von unbestimmten Werten geführt, an dessen zweitem Eingang ein binäres Steuersignal $S_1$ anliegt und dessen Ausgang mit einem ersten Eingang E1 eines erfindungsgemäßen Kompaktors K 60 verbunden ist.

Der Ausgang A2 ist zur Maskierung von unbestimmten Werten in einen ersten Eingang eines OR-Gatters 66 geführt, an dessen zweitem Eingang ein binäres Steuersignal $s_2$ anliegt und dessen Ausgang mit einem zweiten Eingang E2 des erfindungsgemäßen Kompaktors K 60 verbunden ist.

Diese Struktur setzt sich für alle Ausgänge A3 bis AM fort.

Wird durch vorhergehende Untersuchungen für einen bestimmten Zeitpunkt etwa am Ausgang A2 des Scan-Pfades S2 63 ein unbestimmter Wert oder ein X-Wert vorhergesagt, dann kann der unbestimmte Wert auf den Wert 1 am Eingang E2 festgesetzt bzw. maskiert werden, indem man einfach das Steuersignal $s_2$ für diesen Zeitpunkt t zu 1 wählt. Zu den Zeitpunkten, wo kein X-Wert vorhergesagt wird, wird das Steuersignal einfach gleich 0 gewählt. Ganz analog lassen sich x-Werte bzw. unbestimmte Werte an den anderen Ausgängen der zu testenden und/oder zu diagnostizierenden Schaltung maskieren. Beispielsweise können die Steuervariablen $s_1$, $s_2$, ... ,$s_M$ vom Tester bereitgestellt werden oder auch für jeden Testinput-Vektor für jeden Scan-Pfad in einem Register abgelegt sein. Die Vergleichsvektoren $v_1$, ... ,$v_k$, die vom Tester 61 in den erfindungsgemäßen Kompaktor eingegeben werden, sind dann so zu wählen, dass immer dort, wo ein unbestimmter Wert in der zu testenden und/oder zu diagnostizierenden Schaltung auftritt, der Wert "unbestimmter Wert" durch den definierten Wert "1" ersetzt werden kann.

Werden etwa anstelle der gesteuerten OR-Gatter 65, 66, 67 gesteuerte AND-Gatter zur Maskierung verwendet, dann ist immer dann, wenn ein X-Wert maskiert wird, der maskierte X-Wert durch den definierten Wert "0" zu ersetzen.

In Fig. 7 ist eine weitere Anwendung eines erfindungsgemäßen Kompaktors zum Test und/oder zur Diagnose einer Schaltung mit X-Werten dargestellt. Die Ausgänge A1, ..., AM der zu testenden und/oder zudiagnostizierenden Schaltung, die in Fig. 7 nicht eingezeichnet sind, sind mit den Eingängen E1, ...,EM eines erfindungsgemäßen Kompaktors K70 verbunden.

Der erfindungsgemäße Kompaktor K70 mit den Eingängen E1,...,EM und den Syndromausgängen S1',...Sm' ist um eine Schaltung aus m XOR-Gattern 81,...,8m, aus m AND-Gattern 71,...,m, aus m Multiplexern 101,...,10m, aus einem OR-Gatter 77 und einem weiteren AND-Gatter 79 ergänzt, um mit dieser Ergänzung X-Werte verarbeiten zu können. Die Erfindung ist hier also ein Kompaktor, der einem der obenstehend beschriebenen Kompaktoren entspricht und der zusätzlich externe Schaltungselemente aufweist.

Hier ist es nicht unbedingt erforderlich, dass die X-Werte an den Schaltungsausgängen der zu testenden und zu diagnostizierenden Schaltung bei Ihrem Auftreten zu 0 (oder zu 1) maskiert werden. Hier wird der Fall der nicht-maskierten x-Werte behandelt.

Die Syndromausgänge des Kompaktors K 70 sind hier im Unterschied zu den Kompaktoren in den Figuren 1,2,3,4,5,6 nicht mit S1,...,Sm, sondern mit S1',...,Sm' bezeichnet, da sie hier Zwischensyndrome darstellen. Liegen keine X-Werte vor, dann sind die Zwischensyndrome gleich den Syndromen der zu erkennenden oder zu diagnostizierenden Fehler. Treten X-Werte auf, dann werden diese Zwischensyndrome, wenn unbestimmte oder X-Werte am Eingang des Kompaktors K 70 anliegen, die den Wert 1 annehmen, in die tatsächlichen Syndrome S1,...,Sm der aufgetretenen Fehler korrigiert. Diese korrigierten Syndromwerte ermöglichen die Diagnose fehlerhafter Ausgänge der getesteten oder diagnostizierten Schaltung, und zwar unabhängig davon, welcher Wert (0 oder 1) bei einem unbestimmten Wert X tatsächlich aufgetreten ist.

Für die in Fig. 7 dargestellte Schaltung ist angenommen worden, dass der fehlerkorrigierende Kode für den Kompaktor K 70 ein verallgemeinerter Hamming Kode ist. Der Kompaktor K 70 erzeugt dann an dem Ausgang, der das m-te Zwischensyndrom Sm' führt, die Parität aller seiner durch den Vergleichsvektor v kompensierten Eingangswerte E1,...,EM. Die "Parität" wird hier als XOR-Summe verstanden. Der vom Tester bereitgestellte Vergleichsvektor v ist dabei so bestimmt, dass er die fehlerfreien Testeingaben zu Null kompensiert, wenn kein X-Wert auftritt. Dies ist möglich, weil Testdaten und Vergleichsvektor vorher durch Simulation aufeinander abgestimmt werden.

Tritt ein unbestimmter Wert auf, dann wird der Vergleichsvektor v so bestimmt, als ob der unbestimmte Wert stets 0 ist. Ist der X-Wert tatsächlich gleich 0, dann kompensiert der Vergleichsvektor v die fehlerfreien Testeingaben zu 0. Ist der X-Wert aber tatsächlich gleich 1., dann kompensiert der Vergleichsvektor v die fehlerfreien Testeingaben nicht völlig, sondern zu einem Syndromwert ungleich 0. Das nun durch den X-Wert 1 hervorgerufene Syndrom entspricht einem Fehlersyndrom, das von einem 1-Bit Fehler an dem gleichen Eingang erzeugt würde, an dem der X-Wert auftritt. Durch einen m-dimensionalen Korrekturvektor w, der ebenfalls von Tester bereitgestellt wird, wird dieses dem X-Wert 1 entsprechende Syndrom zu 0 korrigiert.

Die Schaltung, die den erfindungsgemäßen Kompaktor 70 in Fig.7 ergänzt, soll nun beschrieben werden.

Für i= 1, ..., m ist der den Zwischensyndromwert Si' führende Ausgang des Kompaktors K 70 mit dem ersten Eingang des XOR-Gatters 8i und gleichzeitig mit dem 0-Eingang des Multiplexers 10i verbunden. Am zweiten Eingang des XOR-Gatters 8i liegt der Ausgang des AND-Gatters 7i an. In den ersten Eingang dieses AND-Gatters 7i ist der das Fehlersignal f tragende Ausgang des Kompaktors 70 geführt.

Vom Tester 78 wird neben dem bisher beschriebenen in den Kompaktor K 70eingegebenen k Bit breiten Vergleichsvektor v ein weiterer m Bit breiter Korrekturvektor w = w1,w2,...,wm zur Korrektur des Zwischensyndromes S1',...,Sm' bereitgestellt. Die i-te Komponente wi dieses Korrekturvektors liegt an dem zweiten Eingang des AND-Gatters 7i an.

Die Komponenten w1, w2, ..., wm des Korrekturvektors können auch als Maskierungswerte für das Fehlersignal f angesehen werden.

Der Ausgang des XOR-Gatters 8i ist gleichzeitig in den 1-Eingang des Multiplexers 10i und in den i-ten Eingang des OR-Gatters 77 geführt, das an seinem Ausgang ein Fehlersignal f' ausgibt.

Der Ausgang des Kompaktors K 70, der die m-te Komponente Sm' des Zwischensyndromes trägt, ist darüber hinaus invertiert in den ersten Eingang des AND-GAtters 79 geführt, dessen zweiter Eingang mit dem das Fehlersignal f' tragenden Ausgang des OR-Gatters 77 verbunden ist.

Der Ausgang des AND-Gatters 79 ist mit den Steuereingängen der Multiplexer101,102, ..., 10n verbunden. Die Ausgänge der Multiplexer 101,102,...,10m führen die korrigierten Syndromwerte S1,S2,...,Sm.

Die Funktionsweise der in Fig. 7 dargestellten Schaltung soll nun erläutert werden.

Zunächst betrachten wir den Fall, dass kein unbestimmter Wert an den Eingängen E1,...,EM des Kompaktors 70 anliegt. In diesem Fall ist der vom Tester bereitgestellte Korrekturvektor w = w1,...,wm = 0,...,0.

Liegt kein Fehler in der zu testenden und/oder zu diagnostizierenden Schaltung vor, dann sind sowohl die Komponenten S1', ...,Sm' als auch das Fehlersignal f gleich 0. Auch der vom Testerausgegebene Korrekturvektor w nimmt für alle seine Komponenten den Wert 0 an. Für i= 1, ...,m wird in dem XOR-Gatter 8i der Wert 0 mit Si' XOR-verknüpft, so dass Si = Si' XOR 0 = Si' = 0 gilt und f' = 0 (kein Fehler) ausgegeben wird. Da das Fehlersignal f' gleich 0 ist, liegt das Steuersignal c_M = 0 an den Steuereingängen der Multiplexer 101,102, ...,10m an und die Werte der Syndrome S1 = S1' = 0, S2 = S2'= 0, ..., Sm = Sm'= 0 werden an den Ausgängen ausgegeben.

Liegt nun ein Fehler an einem der Eingänge E1,...,EM des Kompaktors K 70 an, dann wird dieser Fehler durch den vom Tester bereitgestellten Vektor v nicht zu 0 kompensiert. Das Fehlersignal f nimmt den Wert 1 an und das Syndrom des Fehlers wird an den Ausgängen S1', ...,Sm' des Kompaktors K 70 als Zwischensyndrom ausgegeben. Da kein X-Wert vorliegt, ist der ebenfalls vom Tester bereitgestellte Korrekturvektor w = $w_1$, ..., $w_m$ = (0, ...,0) gleich 0. Für i = 1, ...,m wird in dem XOR-Gatter 8i der Wert 0 mit Si' XOR-verknüpft, so dass Si = Si' XOR 0 = Si' gilt und f' = 1 (Fehler) ausgegeben wird.

Handelt es sich um einen 1-Bit-Fehler, so ist Sm' = 1, und der Wert $\overline{Sm'}$ = 0 liegt am ersten Eingang des AND-Gatters 79 an. Das AND-Gatter 79 gibt den Wert $c_M$ = 0 aus, der an den Steuerinputs der Multiplexer 101,102, ...,10m anliegt. Damit werden die vom Kopmpaktor K 70 ausgegebenen Zwischensyndromwerte S1',S2', ...,Sm' an den Ausgängen der Multiplexer 101, ...,10m ausgegeben. Für i = 1,...,m gilt Si = Si' und die Werte der Zwischensyndrome sind hier gleich den Werten der Syndrome des anliegenden Fehlers.

Wir nehmen nun an, dass ein unbestimmter Wert, 0 oder 1, der als X-Wert bezeichnet wird, an einem Eingang Ej zu einem bestimmten zeitpunkt t anliegt. Der Zeitpunkt t und der Eingang Ej sind bekannt, der konkrete Wert 0oder 1 sind unbekannt. Der vom Tester ausgegebene k-dimensionale binäre Vergleichsvektor v wird nun so bestimmt, als ob der unbestimmte Wert am Eingang Ej stets den Wert 0 annehmen würde.

Damit gilt für diesen Vergleichsvektor

$$v(t) = H \times (E1(t),..., Ej - 1(t), 0, Ej + 1,..., EM)^T$$

Wobei H die Kontroll- oder Paritätsprüfmatrix des betrachteten linearen fehlerkorrigierenden Kodes ist und wobei (E1(t), ...,Ej-1(t),0,Ej+1, ...,EM)$^T$ den transponierten - oder Spaltenvektor bezeichnet.

Der m-dimensionale binäre Korrekturvektor w wird so bestimmt, dass gilt

$$w = H \times (\underbrace{0,...,0,1}_{j} 0,...,0)^T$$

wobei H wieder die Kontroll- oder Paritätsprüfmatrix des betrachteten linearen fehlerkorrigierenden Kodes ist und wobei $(\underbrace{0,...,0,1}_{j} 0,...,0)^T$ den transponierten Vektor oder Spaltenvektor bezeichnet.

Man bemerkt, dass der Wert w = S1', ..., Sm' vom Kompaktor K 30 bei Eingabe von E1, ..., EM = $(\underbrace{0,...,0,1}_{j} 0,...,0)$ und $v_1$, ..., $v_k$ = 0, ...,0 ausgegeben wird.

Zur Erläuterung der Funktionsweise betrachten wir noch die folgenden beiden Fälle.

Im ersten Fall nimmt am Eingang Ej der X-Wert den Wert 0 an und es tritt kein Fehler in der zu testenden und diagnostizierenden Schaltung auf.

In diesem Fall gibt der Kompaktor K 70 sowohl an den das zwischensyndrom S1', ...,Sm' tragenden Ausgängen als auch an den das Fehlersignal f tragenden Ausgang die Werte 0 aus. Die Komponenten des vom Tester 78 bereitgestellten Korrekturvektors $w_1$, ...,$w_m$ werden in den AND-Gattern 71, 72, ... 7m mit dem Fehlersignal f= 0 jeweils zu 0 verknüpft. Die von Kompaktor K 70 ausgegebenen Komponenten des Zwischensyndroms S1'=0,..., Sm' = 0 werden jeweils mit 0 in den XOR-Gattern 81,82,... 8m zu 0 verknüpft. Somit ist das das vom OR-Gatter 77 ausgegebene Fehlersignal f' gleich 0. Das Signal $c_M$, das am Ausgang des AND-Gatters 79 ausgegeben wird ist ebenfalls gleich 0, und die Multiplexer 101,102,...,10m verbinden jeweils ihren 0-Eingang mit ihrem Ausgang. Damit werden die Werte S1 = S1' = 0,...,Sm = Sm'= 0 als Syndromwerte an den Ausgängen der Multiplexer 101,...,10m ausgegeben.

Im zweiten Fall nimmt am Eingang Ej der X-Wert den Wert 1 zu einem Zeitpunkt t an und es tritt zum gleichen Zeitpunkt ein Ein-Bit Fehler in der zu testenden und diagnostizierenden Schaltung auf.

In diesem Falle gibt der Kompaktor K 70 das Fehlersyndrom S1', ...,Sm' aus, das sowohl den angenommenen Einbit-Fehler als auch den X-Wert 1 berücksichtigt. Das Fehlersignal ist f= 1.

Da das Fehlersignal f = 1 ist, werden die an den ersten Eingängen der AND-Gatter 71,72, ...,7m anliegenden Komponenten des vom Tester bereitgestellten Korrekturvektors w = $w_1$, ...,$w_m$) unverändert an den Ausgängen dieser AND-Gatter 71, ..., 7m ausgegeben und in den XOR-Gattern 81, 82, ..., 8m mit den Komponenten S1', ...,Sm' des Zwischensyndroms verknüpft.

Dadurch wird der X-Wert 1, der am Eingang Ej des Kompaktors K 70 anliegt, an den Ausgängen der XOR-Gatter 81,82, ...,8m kompensiert. Das an den Ausgängen der XOR-Gatter anliegende korrigierte Syndrom enthält nun nur noch die Fehlerinformation des angenommenen Ein-Bit Fehlers. Die Komponente Sm' des Zwischensyndroms bestimmt die Gesamtparität der kompensierten Eingänge des Kompaktors 70. Die Komponente Sm' des Fehlersyndroms ist aufgrund des zum Zeitpunkt t gleichzeitig aufgetretenen X-Wertes 1 und des angenommenen 1-Bit Fehlers gleich 0.

Das durch w korrigierte Zwischensyndrom wird an den Ausgängen der XOR-Gatter81,...,8m ausgegeben. Die Korrektur durch w berücksichtigt den Wert 1 des X-Wertes aber nicht den gleichzeitig auftretenden Fehler der zu testenden und zu diagnostizierenden Schaltung, und die Ausgänge der XOR-Gatter 81,...,8m sind nicht gleich 0,...,0.

Das OR-Gatter 77 gibt das Fehlersignal f' = 1 aus. An den Eingängen des UND-Gatters 79 liegen die Werte f'= 1 und $\overline{Sm'}$ = 1 an. Damit ist das Steuersignal $c_M$ der Multiplexer 101,102, ..., 10m gleich 1. Die Ausgänge der XOR-Gatter 81,82, ...,8m, die die bezüglich des X-Wertes 1 korrigierten Werte des Fehlersyndromes S1,S2, ...,Sm tragen, werden durch die Multiplexer 101,102, ...,10m an die Ausgänge weitergeleitet. Das Fehlersignal f' = 1 zeigt an, dass ein Fehler vorliegt. Die Funktion der anderen möglichen Fälle der Fehlererkennung erfolgen ganz analog zu den oben beschriebenen Beispielen und sie sollen deshalb hier nicht weiter erläutert werden.

Fig. 10 zeigt eine weitere vorteilhafte Ausgestaltung eines erfindungsgemäßen Kompaktors, wenn unbestimmte oder X-Werte in der zu testenden und/oder zu diagnostizierenden Schaltung auftreten.

Der Kompaktor in Fig. 10 hat die Eingänge E1, E2, ..., E10 an die die Ausgänge der zu testenden und /oder diagnstizierenden Schaltung angeschlossen sind und die fünf Syndromausgänge S1, S2,S3,S4, S5 und einen weiteren das Fehlersignal f tragenden Ausgang. Als fehlerkorrigierender Kode wird hier ein Kode mit der H-matrix

$$H = \begin{pmatrix} 1 & 1 & 1 & 1 & 0 & 0 & 0 & 0 & 0 & 0 \\ 1 & 0 & 0 & 0 & 1 & 1 & 1 & 0 & 0 & 0 \\ 0 & 1 & 0 & 0 & 1 & 0 & 0 & 1 & 1 & 0 \\ 0 & 0 & 1 & 0 & 0 & 1 & 0 & 1 & 0 & 1 \\ 0 & 0 & 0 & 1 & 0 & 0 & 1 & 0 & 1 & 1 \end{pmatrix}$$

gewählt.

Der Eingang E1 ist gleichzeitig mit dem ersten Eingang des XOR-Gatters 101 und mit dem ersten Eingang des XOR-Gatters 104 verbunden,

Der Eingang E2 ist gleichzeitig mit dem zweiten Eingang des XOR-Gatters 101 und mit dem ersten Eingang des XOR-Gatters 103 verbunden.

Der Eingang E3 ist gleichzeitig mit dem ersten Eingang des XOR-Gatters 103 und mit dem ersten Eingang des XOR-Gatters 105 verbunden.

Der Eingang E4 ist gleichzeitig mit dem zweiten Eingang des XOR-Gatters 102 und mit dem ersten Eingang des XOR-Gatters 107 verbunden.

Der Eingang E5 ist mit dem zweiten Eingang des XOR-Gatters 103 und mit dem zweiten Eingang des XOR-Gatters 104 verbunden.

Der Eingang E6 ist mit dem zweiten Eingang des XOR-Gatters 105 und mit dem ersten Eingang des XOR-Gatters 106 verbunden.

Der Eingang E7 ist mit dem zweiten Eingang des XOR-Gatters 106 und mit dem zweiten Eingang des XOR-Gatters 107 verbunden.

Der Eingang E8 ist mit dem ersten Eingang des XOR-Gatters 108 und mit dem ersten Eingang des XOR-Gatters 1010 verbunden.

Der Eingang E9 ist mit dem zweiten Eingang des XOR-Gatters 108 und mit dem ersten Eingang des XOR-Gatters 109 verbunden.

Der Eingang E10 ist mit dem zweiten Eingang des XOR-Gatters 109 und mit dem zweiten Eingang des XOR-Gatters 1010 verbunden.

Der Ausgang des XOR-Gatters 101 ist in den ersten Eingang des XOR-Gatters 1011 geführt. Dessen zweiter Eingang ist mit dem Ausgang des XOR-Gatters 102 verbunden und dessen Ausgang ist mit dem zweiten Eingang des XOR-Gatters 1016 verbunden. Am ersten Eingang des XOR-Gatters 1016 liegt der vom Tester bereitgestellte Vergleichwert $v_1$ an. Der Ausgang des XOR-Gatters 1016 ist in den ersten Eingang des AND-Gatters 1021 geführt. An dessen zweitem Eingang liegt der ebenfalls vom Tester bereitgestellte Steuerwert $u_1$ zur Maskierung eines eventuell vorhergesagten X-Wertes an. Der Ausgang des AND-Gatters 1021 ist gleichzeitig mit dem Syndromausgang S1 und gleichzeitig mit dem ersten Eingang des OR-Gatters 1026 verbunden, an dessen Ausgang das Fehlersignal f ausgegeben wird.

Der Ausgang des XOR-Gatters 104 ist in den ersten Eingang des XOR-Gatters 1012 geführt und dessen zweiter Eingang ist mit dem Ausgang des XOR-Gatters 106 verbunden. Dessen Ausgang ist mit dem zweiten Eingang des XOR-Gatters 1017 verbunden. Am ersten Eingang des XOR-Gatters 1017 liegt der vom Tester bereitgestellte Vergleichwert $v_2$ an. Der Ausgang des XOR-Gatters 1017 ist in den ersten Eingang des AND-Gatters 1022 geführt. An dessen zweitem Eingang liegt der ebenfalls vom Tester bereitgestellte Steuerwert $u_2$ zur Maskierung eines eventuell vorhandenen X-Wertes an. Der Ausgang des AND-Gatters 1022 ist gleichzeitig mit dem Syndromausgang S2 und mit dem zweiten Eingang des OR-Gatters 1026 verbunden, an dessen Ausgang des Fehlersignal f ausgegeben wird.

Der Ausgang des XOR-Gatters 103 ist in den ersten Eingang des XOR-Gatters 1013 geführt und dessen zweiter Eingang ist mit dem Ausgang des XOR-Gatters 108 verbunden. Dessen Ausgang ist mit dem zweiten Eingang des XOR-Gatters 1018 verbunden. Am ersten Eingang des XOR-Gatters 1018 liegt der vom Tester bereitgestellte Vergleichwert $v_3$ an. Der Ausgang des XOR-Gatters 1018 ist in den ersten Eingang des AND-Gatters 1023 geführt, an dessen zweitem Eingang der ebenfalls vom Tester bereitgestellte Steuerwert $u_3$ zur Maskierung eines eventuell vorhandenen X-Wertes anliegt. Der Ausgang des AND-Gatters 1023 ist gleichzeitig mit dem Syndromausgang S3 und mit dem dritten Eingang des OR-Gatters 1026 verbunden, an dessen Ausgang das Fehlersignal f ausgegeben wird.

Der Ausgang des XOR-Gatters 105 ist in den ersten Eingang des XOR-Gatters 1014 geführt, dessen zweiter Eingang mit dem Ausgang des XOR-Gatters 1010 verbunden ist. Dessen Ausgang ist mit dem zweiten Eingang des XOR-Gatters 1019 verbunden, an dessen ersten Eingang der vom Tester bereitgestellte Vergleichwert $v_4$ anliegt. Der Ausgang des XOR-Gatters 1019 ist in den ersten Eingang des AND-Gatters 1024 geführt, an dessen zweitem Eingang der ebenfalls vom Tester bereitgestellte Steuerwert $u_4$ zur Maskierung eines eventuell vorhandenen X-Wertes anliegt. Der Ausgang des AND-Gatters 1024 ist gleichzeitig mit dem Syndromausgang S4 und mit dem vierten Eingang des OR-Gatters 1026 verbunden, an dessen Ausgang des Fehlersignal f ausgegeben wird.

Der Ausgang des XOR-Gatters 107 ist in den ersten Eingang des XOR-Gatters 1015 geführt, dessen zweiter Eingang mit dem Ausgang des XOR-Gatters 109 verbunden ist. Dessen Ausgang ist mit dem zweiten Eingang des XOR-Gatters 1020 verbunden, an dessen ersten Eingang der vom Tester bereitgestellte Vergleichwert $v_5$ anliegt. Der Ausgang des XOR-Gatters 1020 ist in den ersten Eingang des AND-Gatters 1025 geführt, an dessen zweitem Eingang der ebenfalls vom Tester bereitgestellte Steuerwert $u_5$ zur Maskierung eines eventuell vorhandenen X-Wertes anliegt. Der Ausgang der AND-Gatters 1025 ist gleichzeitig mit dem Syndromausgang S5 und mit dem fünften Eingang des OR-Gatters 1026 verbunden, an dessen Ausgang des Fehlersignal f ausgegeben wird.

Die Maskierung eines unbestimmten oder X-Wertes soll nun noch an einem Beispiel verdeutlicht werden. Liegt beispielsweise zu einem bestimmten Zeitpunkt t ein X-Wert am Eingang E2 des Kompaktors von Fig. 10 an, dann ist durch die vorhergehende Simulation des Falls zwar der Zeitpunkt t bekannt, aber es ist nicht bekannt, ob der dann anliegende Wert 1 oder 0 ist, was aber nicht als Fehler der Schaltung anzusehen ist. Es soll daher in dieser Situation vermieden werden, dass am Ausgang des OR-Gatters ein Fehlersignal f = 1 und an den Syndromausgängen S1, ..., S5 ein Fehlersyndrom ungleich 0,0,0,0,0 ausgegeben wird.

Man bemerkt, dass sich der unbestimmte Wert am Eingang E2 über die Gatter 1010, 1011, 1016 und 1021 auf den Syndromausgang S1 und auf das Fehlersignal f des Gatters 1026 auswirken kann, wenn der von Tester bereitgestellte Steuerwert $u_1$ des AND-Gatters 1021 gleich 1 ist. Dies wirkt sich allerdings nicht aus, wenn der Steuerwert $u_1$ dieses Gatters gleich 0 ist.

Ebenso bemerkt man, dass sich der unbestimmte Wert am Eingang E2 gleichzeitig über die Gatter 103, 1013, 1018 und 1023 auf den Syndromausgang S3 und auf das Fehlersignal des Gatters 1026 auswirken kann, wenn der vom Tester bereitgestellte Steuerwert u_3 des AND-Gatters 1023 gleich 1 ist. Dies wirkt sich allerdings nicht aus, wenn der Steuerwert $u_3$ gleich 0 ist.

Gibt nun einfach der Tester für den Zeitpunkt t für die Steuersignale $u_1$ und $u_3$ jeweils den Wert 0 vor, dann werden die Syndromausgänge, auf die sich der unbestimmte Wert auswirken könnte, gleich 0 gesetzt und der unbestimmte Wert wird maskiert.

Die Syndromausgänge S2, S4 und S5 werden durch den unbestimmten Wert am Eingang E2 nicht beeinflusst. Zum Zeitpunkt t, wo der unbestimmte Wert am Eingang E2 auftritt, können sie weiterhin zur Fehlererkennung und zur Diagnose verwendet werden. Dies wirkt sich im Test zeitsparend aus, weil sonst der Test zu unrecht als fehlerhaft abgebrochen würde.

Das Maskieren von unbestimmten Werten ausschließlich an den Ausgängen einer zu testenden und/ oder zu diagnostizierenden Schaltung hat im Vergleich zu dem beschriebenen Verfahren den Nachteil, dass bei den Praxis relevanten Schaltungen beispielsweise mit ca. 1000 Ausgängen, die etwa Ausgänge von Scan-Ketten sein können, eine Vielzahl von Steuerinformationen vom Tester zur Verfügung gestellt werden muss, was nachteilig ist. Man bemerkt, dass das Maskieren von unbestimmten Werten in Zusammenhang mit einem erfindungsgemäßen Kompaktor vorteilhaft ist, da das Maskieren der unbestimmten Werte an wesentlich weniger Leitungen, in dem in Fig. 10 dargestellten Beispiel sogar nur ausschließlich an den Syndromausgängen, erfolgen kann, was wesentlich weniger Steuerinformation erfordert, die von Tester aufwendig bereitgestellt werden muss.

Nachfolgend wird ausgeführt, wie für die Signale v und u eine gemeinsame Leitung benutzt werden kann. Das Maskieren von unbekannten bzw. unbestimmten Werten kann effizient mit dem in der DE 103 35 809.9 beschriebenen Schaltungselement durchgeführt werden. Das dort beschriebene Element konvertiert ein dreiwertiges Eingangssignal E mit den möglichen Signalwerten '0', '1' und 'Z' in zwei binäre Ausgangssignale $A_1$ und $A_2$ mit den möglichen Signalwerten '0' und '1'. Tabelle 1 zeigt die Zuordnung von Eingangs- zu Ausgangssignalwerten.

| Eingang $E$ | Ausgang $A_1$ | Ausgang $A_2$ |
|---|---|---|
| 0 | 0 | 1 |
| 1 | 1 | 1 |
| Z | 0 oder 1 | 0 |

Gemäß Figur 10 wird für jedes Paar von Vergleichs-, $v_i$, und Maskierungssignalen, $u_i$, ein solches Schaltungselement verwendet. Die Eingänge $E_i$ werden mit dem externen Tester, die Ausgänge $A_{1,i}$ mit den Vergleichssignalen $v_i$ und die Ausgänge $A_{2,i}$ mit den Maskierungssignalen $u_i$ verbunden.

Tritt kein zu maskierender unbekannter Wert innerhalb der Schaltung auf, wird vom externen Tester der zu vergleichende Erwartungswert, ‚0' oder ‚1', angelegt. Tritt ein zu maskierender unbekannter Wert auf, wird vom externen Tester der Wert 'Z' angelegt. Das führt dazu, dass die entsprechenden Maskierungselemente, 1021 bis 1025 in Figur 10, den unbekannten Wert ausblenden und dafür einen definierten und bekannten Wert '0' an ihrem Ausgang liefern.

Durch das Ausblenden wird verhindert, dass das Fehlersignal $f$ durch einen unbekannten Signalwert, der für den Test unerheblich ist, fälschlicherweise auf '1' gesetzt wird. Ferner wird erreicht, dass für das Syndrom $S$ immer alle Syndromwerte $S_i$ bekannt sind.

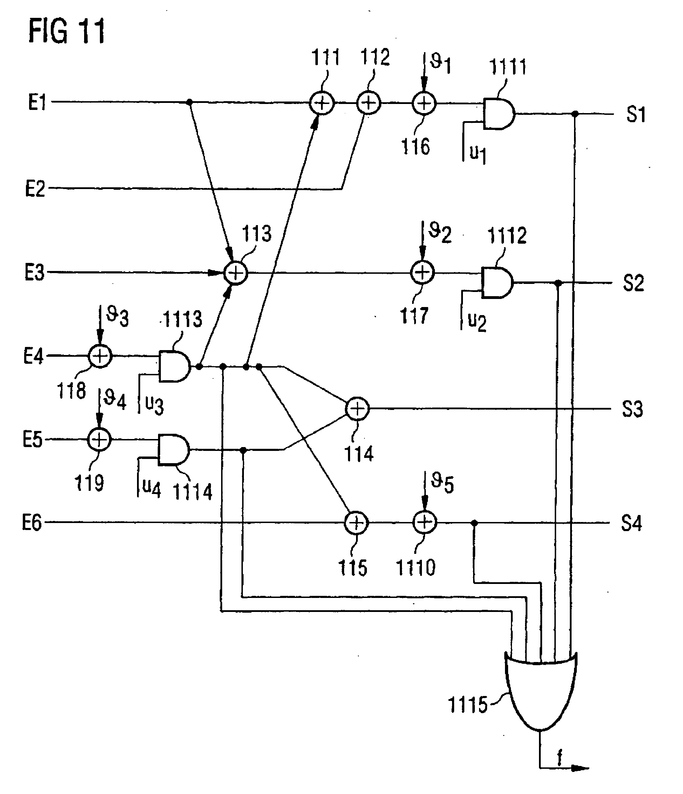

Fig. 11 zeigt eine weitere Ausgestaltung eines erfindungsgemäßen Kompaktors , wenn unbestimmte Werte bzw. X-Werte in der zu testenden und/ oder zu diagnostizierenden Schaltung auftreten. Der Kompaktor in Fig. 11 hat 6 Eingänge E1, ..., E6 an die die Ausgänge der zu testenden und/oder zu diagnostizierenden Schaltung angeschlossen werden und vier Syndromausgänge S1, S2, S3, S4.

Der Eingang E1 ist gleichzeitig mit dem ersten Eingang des XOR-Gatters 111 und mit dem ersten Eingang des XOR-Gatters 113 verbunden.

Der Eingang E2 ist mit dem zweiten Eingang des XOR-Gatters 112 verbunden, dessen erster Eingang mit dem Ausgang des XOR-Gatters 111 verbunden ist. Der Eingang E3 ist mit dem zweiten Eingang des XOR-Gatters 113 verbunden.

Der Eingang E4 ist mit dem zweiten Eingang des XOR-Gatters 118 verbunden, an dessen erstem Eingang der vom Tester bereitgestellte Vergleichswert $v_3$ anliegt und dessen Ausgang in den ersten Eingang des AND-Gatters 1113 geführt ist an dessen zweitem Eingang das ebenfalls von Tester bereitgestellte Signal $u_3$ zur Maskierung von X-Werten anliegt. Der Eingang E5 ist mit dem zweiten Eingang des XOR-Gatters 119 verbunden, an dessen erstem Eingang der vom Tester bereitgestellte Vergleichswert $v_4$ anliegt und dessen Ausgang in den ersten Eingang des AND-Gatters 1114 geführt ist an dessen zweitem Eingang das ebenfalls von Tester bereitgestellte Signal $u_4$ zur Maskierung von X-Werten anliegt.

Der Eingang E6 ist mit dem zweiten Eingang des XOR-Gatters 115 verbunden, dessen erster Eingang mit dem Ausgang des AND-Gatters 1113 verbunden ist, der gleichzeitig in den ersten Eingang des XOR-Gatters 114 und in den ersten Eingang des OR-Gatters 1115 geführt ist.

Der Ausgang des AND-Gatters 1114 ist gleichzeitig mit dem zweiten Eingang des XOR-Gatters 114 und mit dem zweiten Eingang des OR-Gatters 1115 verbunden.

Der Ausgang des XOR-Gatters 112 ist mit dem zweiten Eingang des XOR-Gatters 116 verbunden, an dessen erstem Eingang das vom Tester bereitgestellte Vergleichssignal $v_1$ anliegt und dessen Ausgang in den ersten Eingang des AND-Gatters 1111 geführt ist, an dessen zweitem Eingang das vom Tester bereitgestellte Signal $u_1$ zur Maskierung von X-Werten anliegt und dessen Ausgang gleichzeitig mit dem Syndromausgang S1 und mit dem fünften Eingang des OR-Gatters 1115 verbunden ist.

Der Ausgang des XOR-Gatters 113 ist mit dem zweiten Eingang des XOR-Gatters 117 verbunden, an dessen erstem Eingang das vom Tester bereitgestellte Vergleichssignal $v_2$ anliegt und dessen Ausgang in den ersten Eingang des AND-Gatters 1112 geführt ist, an dessen zweitem Eingang das vom Tester bereitgestellte Signal $u_2$ zur Maskierung von X-Werten anliegt und dessen Ausgang gleichzeitig mit dem Syndromausgang S2 und mit dem vierten Eingang des OR-Gatters 1115 verbunden ist.

Der Ausgang des XOR-Gatters 114 ist mit dem Syndromausgang S3 verbunden.

Der Ausgang des XOR-Gatters 115 ist mit dem zweiten Eingang des XOR-Gatters 1110 verbunden, an dessen ersten Eingang der von Tester bereitgestellte Vergleichswert $v_5$ anliegt und dessen Ausgang gleichzeitig mit dem Syndromausgang S4 und mit dem dritten Eingang des OR-Gatters 1115 verbunden. Der Ausgang des OR-Gatters 1115 führt das Fehlersignal f.

Bei dem Kompaktor nach Fig. 11 ist angenommen, dass von der zu testenden und/oder zu diagnostizierenden Schaltung an ihrem mit dem Eingang E6 des Kompaktors verbundenen Ausgang keine unbestimmten Werte auftreten und dass somit für diesen Eingang des Kompaktors keine Maskierung unbestimmter Werte erforderlich ist.

Weiter ist angenommen, dass an den mit den Eingängen E4 und E5 verbundenen Ausgängen der zu testenden und/oder zu diagnostizierenden Schaltung S häufig unbestimmte Werte auftreten können, die deshalb schon möglichst nahe am Eingang des Kompaktors maskiert werden sollen, damit sie sich auf die Diagnose anderer Eingangswerte nicht auswirken können. Dies ist erwähnenswert, weil unbestimmte Werte an diesen Eingängen des Kompaktors häufig auftreten und dort günstigerweise gleich direkt maskiert werden können.

Man bemerkt, dass in dem Kompaktor von Fig. 11 X-Werte, die an einer Teilmenge der anderen Eingänge E1, E2, E3, E4 und E5 auftreten, maskiert werden können. Die Maskierung einer anderen Teilmenge von Eingängen, die hier aus dem Eingang E6 besteht, braucht nicht erfolgen, da an dieser Teilmenge von Eingängen keine X-Werte auftreten.

Fig. 8 zeigt das Prinzipschaltbild eines erfindungsgemäßen Kompaktors 81, dessen fehlerhafte Syndromwerte in einem Speicher 82 gespeichert werden, wobei der Speicher 82 auf den Chip oder außerhalb des Chips realisiert sein kann. Die getestete Schaltung, die in Fig. 8 nicht eingezeichnet ist, gibt aufgrund der vom Tester in die zu testende Schaltung eingegebenen Testmuster ihre Testantworten in die Eingänge E1, ... , EM ein. Der Tester stellt gleichzeitig noch die Vergleichswerte $v_1$, ... $v_k$ als zusätzliche Eingaben für den Kompaktor 81 bereit. Dabei kann, wie schon ausgeführt k als ein Wert zwischen M und m gewählt werden. Der Kompaktor 81 gibt an seinen Ausgängen S1, ... Sm die entsprechend dem verwendeten Kode kompaktierten Syndromwerte aus, die in Abhängigkeit von Zusatzsignalen unter verschiedenen, vorzugsweise aufeinander folgenden Adressen in dem Speicher 82 gespeichert werden. Vorzugsweise wird man nur diejenigen Syndromwerte abspeichern, die ungleich 0 sind und die für den gewählten fehlerkorrigierenden Kode einen Fehler in der Schaltung zu diagnostizieren erlauben. Dabei beinhalten die Zusatzsignale die üblichen Steuersignale eines Speichers und beispielsweise die Markierung der Zeitpunkte, zu denen fehlerhafte Syndromwerte an dem Speicher 82 anliegen.

Fig. 9 zeigt eine Ausführungsform eines erfindungsgemäßen Kompaktors, dessen fehlerhafte Ergebnisse in einer Speichereinheit während des Test- und/oder Diagnoseprozesses gespeichert werden. Die getestete Schaltung, die in Fig. 9 nicht eingezeichnet ist, gibt aufgrund der vom Tester in die Schaltung eingegebenen Testmuster ihre Testantworten in die Eingänge E1, ... , EM ein. Der Tester stellt gleichzeitig noch die Vergleichswerte $v_1$, ... $v_k$ als zusätzliche Eingaben für den Kompaktor 91 bereit. Dabei kann wie schon ausgeführt k als ein Wert zwischen M und m gewählt werden.

Der Kompaktor 91 gibt an seinen Ausgängen S1, ..., Sm die entsprechend dem verwendeten Kode kompaktierten Syndromwerte aus. Diese Werte haben den Wert (0, ... ,0) wenn kein Fehler in der zu testenden Schaltung vorliegt. Gleichzeitig gibt der Kompaktor 91 ein Fehlersignal f aus, das gleich 1 ist, wenn in der zu testenden Schaltung ein Fehler vorliegt. Das Fehlersignal ist gleich 0, wenn in der zu testenden Schaltung kein Fehler vorliegt. Das Fehlersignal wird an den ersten Eingang eines AND-Gatters 95 geführt. Der Kompaktor 91 gibt gleichzeitig noch das Signal ndT aus. Dieses Signal ist negiert in den zweiten Eingang des AND-Gatters 95 geführt, dessen Ausgangswert in dem Zähler 93 gezählt wird, dessen Zustand als Adresse an dem Speicher 92 anliegt. Der Ausgang des AND-Gatters dient auch gleichzeitig als Schreib-Enable Signal für den Speicher 92, sodass nur dann in den Speicher 92 unter aufeinanderfolgenden Adressen ein Syndrom geschrieben wird, wenn ein eindeutig aus dem Syndrom zu diagnostizierender Fehler in der Schaltung vorliegt, was sich in einem Wert f= 1 und ndT = 0 ausdrückt. Der Zähler 94 hat hier den Initialzustand 0 und er inkrementiert autonom seinen Zustand in jedem Takt um 1, sodass der Zustand des Zählers den Zeitpunkt angibt, zu dem ein bestimmter Wert des Syndroms am Eingang des Speichers 92 anliegt. Der Zustand des Zählers 94 wird gleichzeitig mit dem Syndrom gespeichert, wenn der Ausgang des AND-Gatters 95 gleich 1 ist. Man bemerkt, dass in dem Speicher 92 die Syndromwerte ungleich 0, die eine eindeutige Diagnostizierbarkeit des in der Schaltung ausgegebenen Fehlers ermöglichen, gemeinsam mit dem zeitpunkt ihres Auftretens gespeichert sind.

Die Steuersignale, etwa die Schreib- und Lesesignale, die Taktsignale u.a. sind in Fig. 9 nicht eingezeichnet, da die Implementierung eines Speichers einem Fachmann bekannt sind. Der Speicher 92 kann dabei auf dem getesteten Chip oder auch als Zusatzeinheit implementiert sein. Das Auslesen der Daten aus dem Speicher 92 kann z. B. nach Beendigung des Testes erfolgen, wobei erst dann die fehlerhaften Eingaben in den Kompaktor diagnostiziert werden. Ist die Anzahl der Fehler, die mit Hilfe des verwendeten Kodes diagnostizierbar sind, größer als die Anzahl der Worte, die in dem Speicher 92 gespeichert werden können, so kann beispielsweise, wenn der zähler 93 einen bestimmten größten Zustand erreicht, die Diagnose der betrachteten Schaltung beendet werden. Ebenso ist es möglich, die Daten aus dem Speicher 92 auszulesen, wenn der Speicher 92 gefüllt ist, und dann den Diagnoseprozess fortzusetzen.

Fig. 12 zeigt eine Anordnung aus n erfindungsgemäßen gleichen Kompaktoren K1 1201, ... ,Kn 1202 zum gleichzeitigen Test und/oder zur gleichzeitigen Diagnose von n gleichartigen Schaltungen. Die jeweils M Bit breiten Eingänge , die jeweils m Bit breiten Syndrom-Ausgänge und der 1 Bit breite das Fehlersignal tragende Ausgang sind mit $E^{(1)}$, $S1^{(1)}$, $f^{(1)}$,..., $E^{(n)}$, $S^{(n)}$, $f^{(n)}$ bezeichnet. An die Eingänge $E^{(1)}$ des Kompaktors K1 1201 sind die Ausgänge $A^{(1)}$, ...,

an die Eingänge $E^{(n)}$ des Kompaktors Kn 1202 sind die Ausgänge A(n) der zu testenden und/oder zu diagnostizierenden, jeweils gleich aufgebauten Schaltungen angeschlossen. Der Tester 1203 stellt für alle n Kompaktoren K1 1201, ..., Kn 1203 die gleichen k-dimensionalen Vergleichssignale v zur Verfügung. Liegen in den zu testenden und/oder zu diagnostizierenden gleichartigen Schaltungen unbestimmte Werte vor, so werden vom Tester an die n Kompaktoren weitere, für alle Kompaktoren weitere gleiche Signale, etwa Signale zur Maskierung der unbekannten Werte, wie das in den Ausführungsbeispielen von Fig. 10 und Fig. 11 beschrieben wurde, oder zur Korrektur der X-Werte, wie das in dem Ausführungsbeispiel von Fig. 7 beschrieben wurde, zur Verfügung gestellt.

Werden die von den Kompaktoren ausgegebenen fehlerhaften Syndrome gespeichert, wie das in den Ausführungsbeispielen von Fig. 8 und 9 beschrieben wurde, so sind an die Kompaktoren K1 1201, ..., Kn 1202 jeweils die gleichen Speicher 82, 92 anzuschließen.

Man bemerkt, dass man durch das gleichzeitige Testen und/oder Diagnostizieren von n gleichen Schaltungen den Tester nur einmal zur Verfügung stellen muß, was vorteilhaft ist.

Fig. 13 zeigt, wie eine Schaltung S mit Ausgängen $A_1$ bis AN an die Eingänge $E_1$ bis $E_N$ eines Kompaktors K 10 angeschlossen ist. Der Kompaktor K 10 hat dabei Syndrom-Ausgänge $S_1$ bis $S_m$ sowie ein Fehleranzeigesignal f. Ein Tester T liefert Testdaten SE für die Schaltung S sowie Vergleichsdaten v und Kompensationsdaten w für den Kompaktor K 10.

**Patentansprüche**

1. Schaltungsanordnung mit den folgenden Merkmalen:

   - eine zu testende und/oder zu diagnostizierende elektronische Schaltung S mit einer Anzahl von Schaltungseingängen zur Eingabe von Eingangsdaten und mit einer Anzahl M von Schaltungsausgängen A ($A_1$, ..., AM) zur Ausgabe von M Bit breiten Ausgangsdaten,
   - einen Kompaktor K mit einer Anzahl M von Testdateneingängen ($E_1$, ... ,$E_M$), die mit den Schaltungsausgängen A ($A_1$, ..., AM) verbunden sind, sowie mit einer Anzahl k von Testvergleichseingängen ($v_1^i, \cdots, v_k^i$) und mit einer Anzahl m von Testdatenausgängen ($S_1$, ..., $S_m$),
   - eine Speichervorrichtung (82) für die sich an den Testdatenausgängen ergebenden Daten,

   **dadurch gekennzeichnet, dass**
   die Speichervorrichtung auf einem Halbleiterchip realisiert ist, auf dem die Schaltung S und der Kompaktor K realisiert sind.

2. Schaltungsanordnung nach Anspruch 1,
   **dadurch gekennzeichnet, dass**
   der Kompaktor K eine Anzahl von H-Matrix-XOR-Gattern (1, 2, 3, 4, 5, 6, 7) aufweist, die als Schaltwerk so zwischen den Testdateneingängen ($E_1$, ... ,$E_M$) und den Testdatenausgängen ($S_1$, ..., $S_m$) angeordnet sind, dass die an seinen Testdateneingängen ($E_1$, ... ,$E_M$) anliegenden Daten entsprechend den Koeffizienten einer H-Matrix eines linearen, fehlerkorrigierenden Kodes komprimiert an den Testdatenausgängen ($S_1$, ... , $S_m$) anliegen, und wobei der Kompaktor K weiterhin Kompensations-XOR-Gatter (11, 12, 13, 14, 15, 16; 21, 22, 23, 24; 31, 32, 33, 34; 35, 36, 37, 38) aufweist, die im Bereich zwischen den Testdateneingängen ($E_1$, ... ,$E_M$) und den Testdatenausgängen ($S_1$, ... , $S_m$) angeordnet sind, wobei jeweils ein Eingang eines Kompensations-XOR-Gatters (11, 12, 13, 14, 15, 16; 21, 22, 23, 24; 31, 32, 33, 34; 35, 36, 37, 38) zur Eingabe eines Kompensationswerts vorgesehen ist.

3. Schaltungsanordnung nach Anspruch 1 oder 2,
   **dadurch gekennzeichnet, dass**
   eine oder mehrere Fehleranzeigeschaltungen (91; 92; 93; 310; 39; SwF) vorgesehen sind, deren Eingänge mit wenigstens einem Teil der Leitungen des Kompaktors K verbunden sind und die ein Fehleranzeigesignal (f) ausgibt.

4. Schaltungsanordnung nach einem der Anspruch 3,
   **dadurch gekennzeichnet, dass**
   die Fehleranzeigeschaltung als OR-Gatter (91) ausgebildet ist.

5. Schaltungsanordnung nach einem der Ansprüche 3 bis 4,
   **dadurch gekennzeichnet, dass**

die Fehleranzeigeschaltung als kombinatorisches Schaltwerk (SwF) ausgebildet ist, das ein Fehlersignal (f) dann ausgibt, wenn die Anzahl der an seinen Eingängen anliegenden Fehlersignale einen vorbestimmten Schwellenwert überschreitet.

6.  Schaltungsanordnung nach einem der Ansprüche 1 bis 5,
    **dadurch gekennzeichnet, dass**
    vor einem oder mehreren Testdateneingängen ($E_1$, ... ,$E_M$) eine Maskierungsvorrichtung (65, 66, 67) angeordnet ist, die jeweils einen Maskierungseingang (s1, s2, ..., sm) zur Eingabe eines vorbestimmten Maskierungssignals aufweist.

7.  Schaltungsanordnung nach einem der Ansprüche 1 bis 6,
    **dadurch gekennzeichnet, dass**
    vor einem oder mehreren Testdatenausgängen ($S_1$, ... , $S_m$) des Kompaktors K je eine Maskierungseinrichtung (1110, 1116, 1112, 1114; 1021, 1022, 1023, 1024, 1025) angeordnet ist, die jeweils einen Maskierungseingang (s1, s2, ..., sm; u1, u2, ..., u5) zur Eingabe eines vorbestimmten Maskierungssignals aufweist.

8.  Schaltungsanordnung nach einem der Ansprüche 1 bis 7,
    **dadurch gekennzeichnet, dass**
    zur Verarbeitung von X-Werten eine erste Schaltung mit m XOR-Gattern (81, ..., 8m), mit m AND-Gattern (71, ..., m), mit m Multiplexern (101,..., 10m) vorgesehen ist, wobei für i= 1,..., m der einen Zwischensyndromwert Si' führende Ausgang des Kompaktors K (70) mit dem ersten Eingang eines XOR-Gatters (8i) und gleichzeitig mit dem 0-Eingang eines Multiplexers (10i) verbunden ist und wobei am zweiten Eingang des XOR-Gatters (8i) der Ausgang des AND-Gatters (7i) anliegt, wobei ferner in den ersten Eingang des AND-Gatters (7i) der das Fehlersignal f tragende Ausgang des Kompaktors 70 geführt ist, und wobei an dem zweiten Eingang des AND-Gatters (7i) ein vom Tester bereitgestellter Korrekturwert (wi) anliegt.

9.  Schaltungsanordnung nach Anspruch 8,
    **dadurch gekennzeichnet, dass**
    zur Fehleranzeige beim Auftreten solcher x-Werte eine zweite Schaltung mit wenigstens einem OR-Gatter (77) und mit wenigstens einem weiteren AND-Gatter (79) vorgesehen ist, wobei der Ausgang des XOR-Gatters (8i) gleichzeitig in den 1-Eingang des Multiplexers (10i) und in den i-ten Eingang des OR-Gatters (77) geführt wird, das an seinem Ausgang ein Fehlersignal f ausgibt.

10. Schaltungsanordnung nach einem der Ansprüche 6 bis 9,
    **dadurch gekennzeichnet, dass**
    die Maskierungseinrichtung als OR-Gatter (65, 66, 67), als AND-Gatter (71, 72, ..., 7m), als NOR-Gatter oder als NAND-Gatter ausgebildet ist.

11. Schaltungsanordnung nach einem der Ansprüche 1 bis 10,
    **dadurch gekennzeichnet, dass**
    die Eingänge E des Kompaktors wenigstens teilweise mit Schaltungsausgängen A der Schaltung S verbunden sind, die als Ausgänge von Scanpfaden ausgebildet sind.

12. Verfahren zum Betreiben einer Schaltungsanordnung nach einem der Ansprüche 1 bis 11.

13. Verfahren nach Anspruch 12,
    **dadurch gekennzeichnet, dass**
    in einem Testmodus die Schaltungseingänge so lange mit Eingangsdaten beaufschlagt werden, bis ein Fehleranzeigesignal (f) auftritt.

14. Verfahren nach einem der Patentansprüche 12 bis 13,
    **dadurch gekennzeichnet, dass**
    die an den Testdateneingängen auftretenden Daten im Bereich der getesteten Schaltung abgespeichert werden.

**Claims**

1.  A circuit arrangement, comprising

- an electronic circuit S which is to be tested and/or to be diagnosed and has a number of circuit inputs for inputting input data and has a total number M of circuit outputs A ($A_1$, ..., $A_M$) for outputting output data with a length of M bits,
- compactor K having a number M of test data inputs ($E_1$,..., $A_M$) which are connected to circuit outputs A ($A_1$, ..., $A_M$) and having a total number k of test comparison inputs and a total number m of test data outputs ($S_1$, ..., $S_m$)
- a memory apparatus (82) is provided for the data which is produced at the test data outputs,

**characterized in that**
the memory apparatus is on a semiconductor chip on which the circuit S and the compactor K are provided.

2. A circuit arrangement as claimed in claim 1,
**characterized in that**
the compactor K having a number of H' matrix XOR gates (1, 2, 3, 4, 5, 6, 7) which are arranged as a switching mechanism between the test data inputs ($E_1$, ..., $E_M$) and the test data outputs ($S_1$, ..., $S_m$) in such a way that the data which is applied to its test data inputs ($E_1$, ..., $E_M$) is produced at the test data outputs ($S_1$, ..., $S_m$) compressed in accordance with the coefficients of an H matrix of an error-correcting code,
and wherein the compactor K also has compensation XOR gates (11, 12, 13, 14, 15, 16; 21, 22, 23, 24; 31, 32, 33, 34; 35, 36, 37, 38), which are arranged in the area between the test data inputs ($E_1$, ..., $E_M$) and the test data outputs ($S_1$, ..., $S_m$), wherein in each case one input of a compensation XOR gate (11, 12, 13, 14, 15, 16; 21, 22, 23, 24; 32, 33, 34; 35, 36, 37, 38) is provided for inputting a compensation value.

3. The circuit arrangement as claimed in claim 1 or 2,
**characterized in that**
one or more error indication circuits (91; 92; 93; 310; 39; SwF) are provided whose inputs are at least connected to a part of the signal paths of the compactor K and outputting an error indication signal (f).

4. The circuit arrangement as claimed in claim 3,
**characterized in that**
the error indication circuit is an OR gate (91).

5. The circuit arrangement as claimed in one of the claims 3 to 4,
**characterized in that**
the error indication circuit is a combinational switching mechanism (SwF) that emits an error signal (f) in response to a number of error signals exceeding a predetermined threshold value.

6. The circuit arrangement as claimed in one of the claims 1 to 5,
**characterized in that**
a masking apparatus (65, 66, 67) is arranged upstream of one or more test data inputs ($E_1$, ..., $E_M$) having each a masking input (s1, s2, ..., sm) for applying a predetermined masking signal.

7. The circuit arrangement as claimed in one of the claims to 6,
**characterized in that**
upstream of one or more of the test data outputs ($S_1$, ..., $S_m$) of the compactor K one or more masking devices (1110, 1116, 1112, 1114; 1021, 1022, 1023, 1024, 1025) respectively are arranged having one or more masking inputs (s1, s2, ..., sm; u1, u2, ..., u5) for applying a predetermined masking signal.

8. A circuit arrangement as claimed in one of the claims 1 to 7,
**characterized in that**
a first circuit with m XOR gates (81, ..., 8m) with m AND gates (71, m) and with m multiplexers (101, ..., 10m) is provided for processing X values, with that output of the compactor K (70) which carries an intermediate syndrome value Si for i = 1, ..., m being connected to the first input of an XOR gate (8i) and at the same time being connected to the 0-input of a multiplexer (10i), and with the output of the AND gate (7i) being applied to the second input of the XOR gate (8i), with, furthermore, the output of the compactor 70 which is carrying the error or fault signal f being passed to the first input of the AND gate, and with a correction value (wi), which is provided by the tester, being applied to the second input of the AND gate (7i).

9. A circuit arrangement as claimed in claim 8,
**characterized in that**

a second circuit having at least one OR gate (77) and having at least one further AND gate (79)is provided for error indication when such x values occur, with the output of the XOR gate (8i) at the same time being passed to the 1-input of the multiplexer (10i) and to the i-th input of the OR gate (77) which emits an error or fault signal f at its output.

**10.** A circuit arrangement as claimed in one of the claims 6 to 9 **characterized in that**
the masking device is an OR gate (65, 66, 67), an AND gate (71, 72, ..., 7m), a NOR gate or a NAND gate.

**11.** A circuit arrangement as claimed in one of the claims 1 to 10, **characterized in that**
at least some of the inputs E of the compactor are connected to circuit outputs A of the circuit S which are outputs of scan paths.

**12.** A method for operating a circuit arrangement as claimed in one of the claims 1 to 11.

**13.** A method as claimed in claim 12,
**characterized in that**
the input data is applied to the circuit inputs in a test mode until an error indication signal f occurs.

**14.** A method as claimed in one of the claims 12 to 13,
**characterized in that**
the data which occurs at the test data inputs is stored in the area of the tested circuit.


**Revendications**

**1.** Arrangement de circuit ayant les caractéristiques suivantes :

- un circuit électronique S à tester et/ou à diagnostiquer comprenant un nombre d'entrées de circuit pour l'entrée de données d'entrée et comprenant un nombre M de sorties de circuit A ($A_1$, ..., $A_M$) pour délivrer des données de sortie de M bits de large,
- un compacteur K comprenant un nombre M d'entrées de données de test ($E_1$, .., $E_M$) qui sont reliées avec les sorties de circuit A ($A_1$, ..., $A_M$), ainsi qu'un nombre k d'entrées de comparaison de test $(v_1^i, ..., v_k^i)$ et un nombre m de sorties de données de test ($S_1$, ..., $S_m$),
- un dispositif de mémorisation (82) pour les données obtenues sur les sorties de données de test,

**caractérisé en ce que**
le dispositif de mémorisation est réalisé sur une puce en semiconducteur sur laquelle sont réalisés le circuit S et le compacteur K.

**2.** Arrangement de circuit selon la revendication 1, **caractérisé en ce que**
le compacteur K présente un certain nombre de portes XOR à matrice H (1, 2, 3, 4, 5, 6, 7) qui sont disposées en tant que mécanisme de commutation entre les entrées de données de test ($E_1$, ..., $E_M$) et les sorties de données de test ($S_1$, ..., $S_m$) de telle sorte que les données appliquées à ses entrées de données de test ($E_1$, ..., $E_M$) sont présentes aux sorties de données de test ($S_1$, ...., $S_m$) sous forme comprimée conformément aux coefficients d'une matrice H d'un code linéaire de correction des erreurs,
et le compacteur K présentant en outre des portes XOR de compensation (11, 12, 13, 14, 15, 16 ; 21, 22, 23, 24 ; 31, 32, 33, 34 ; 35, 36, 37, 38) qui sont disposées dans la zone entre les entrées de données de test ($E_1$, $E_M$) et les sorties de données de test ($S_1$, ..., $S_m$), une entrée d'une porte XOR de compensation (11, 12, 13, 14, 15, 16 ; 21, 22, 23, 24 ; 31, 32, 33, 34 ; 35, 36, 37, 38) étant à chaque fois prévue pour l'entrée d'une valeur de compensation.

**3.** Arrangement de circuit selon la revendication 1 ou 2, **caractérisé en ce qu'**un ou plusieurs circuits indicateurs d'erreur (91 ; 92 ; 93 ; 310 ; 39 ; SwF) sont prévus, dont les entrées sont reliées avec au moins une partie des lignes du compacteur K et qui délivrent un signal indicateur d'erreur (f).

**4.** Arrangement de circuit selon la revendication 3, **caractérisé en ce que** le circuit indicateur d'erreur est réalisé sous la forme d'une porte OR (91).

**5.** Arrangement de circuit selon l'une des revendications 3 à 4, **caractérisé en ce que** le circuit indicateur d'erreur est réalisé sous la forme d'un mécanisme de commutation combiné (SwF) qui délivre un signal d'erreur (f) lorsque le nombre de signaux d'erreur appliqués à ses entrées dépasse une valeur de seuil prédéfinie.

6. Arrangement de circuit selon l'une des revendications 1 à 5, **caractérisé en ce qu'**un dispositif de masquage (65, 66, 67) est disposé devant une ou plusieurs entrées de données de test ($E_1$, ..., $E_M$), lequel présente à chaque fois une entrée de masquage (s1, s2, ..., sm) pour l'entrée d'un signal de masquage prédéfini.

7. Arrangement de circuit selon l'une des revendications 1 à 6, **caractérisé en ce qu'**un dispositif de masquage (1110, 1116, 1112, 1114 ; 1021, 1022, 1023, 1024, 1025) est à chaque fois disposé devant une ou plusieurs sorties de données de test ($S_1$, ..., $S_m$) du compacteur K, lequel présente à chaque fois une entrée de masquage (s1, s2, ..., sm ; u1, u2, ..., u5) pour l'entrée d'un signal de masquage prédéfini.

8. Arrangement de circuit selon l'une des revendications 1 à 7, **caractérisé en ce qu'**un premier circuit ayant m portes XOR (81, ..., 8m), m portes AND (71, ..., m), m multiplexeurs (101, ..., 10m) est prévu pour le traitement des valeurs X, pour i = 1, ..., m la sortie du compacteur K (70) qui transporte une valeur de syndrome intermédiaire Si étant reliée avec la première entrée d'une porte XOR (8i) et simultanément avec l'entrée 0 d'un multiplexeur (10i) et la sortie de la porte AND (7i) étant appliquée à la deuxième entrée de la porte XOR (8i), la sortie du compacteur 70 qui transporte le signal d'erreur f étant en plus acheminée à la première entrée de la porte AND (7i) et une valeur de correction (wi) mise à disposition par le testeur étant appliquée à la deuxième entrée de la porte AND (7i).

9. Arrangement de circuit selon la revendication 8, **caractérisé en ce que** pour signaler les erreurs lorsque se produisent de telles valeurs x, il est prévu un deuxième circuit comprenant au moins une porte OR (77) et comprenant au moins une porte AND (79) supplémentaire, la sortie de la porte XOR (8i) étant acheminée simultanément à l'entrée 1 du multiplexeur (10i) et à la i-ème entrée de la porte OR (77) qui délivre à sa sortie un signal d'erreur f'.

10. Arrangement de circuit selon l'une des revendications 6 à 9, **caractérisé en ce que** le dispositif de masquage est réalisé sous la forme d'une porte OR (65, 66, 67), sous la forme d'une porte AND (71, 72, ..., 7m), sous la forme d'une porte NOR ou sous la forme d'une porte NAND.

11. Arrangement de circuit selon l'une des revendications 1 à 10, **caractérisé en ce que** les entrées E du compacteur sont au moins partiellement reliées avec les sorties de circuit A du circuit S, lesquelles sont réalisées sous la forme de sorties de chemins de balayage.

12. Procédé pour mette en oeuvre un arrangement de circuit selon l'une des revendications 1 à 11.

13. Procédé selon la revendication 12, **caractérisé en ce que** dans un mode de test, les données d'entrée sont appliquées aux entrées de circuit jusqu'à ce qu'il se produit un signal indicateur d'erreur (f).

14. Procédé selon l'une des revendications 12 à 13, **caractérisé en ce que** les données produites aux entrées de données de test sont mémorisées dans la zone du circuit testé.

# FIG 1

## FIG 2

# FIG 3

# FIG 4

## FIG 5

## FIG 6

# FIG 7

EP 1 942 349 B1

**FIG 8**

**FIG 9**

# FIG 10

# FIG 11

## FIG 12

## FIG 13

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19536226 A1
- DE 10008674 B4
- DE 10335809

**In der Beschreibung aufgeführte Nicht-Patentliteratur**

- **Dmitriev A. et al.** Robust space compaction of test responses. *TEST SYMPOSIUM,* 18. November 2002, 254-259
- **Patel J H et al.** Application of Saluja-Karpovsky compactors to test responses with many unknowns. *VLSI TEST SYMPOSIUM,* 27. April 2003, 107-112
- **Peterson, W.** Prüfbare und korrigierbare Kodes. *Oldenburg Verlag München und Wien,* 1967
- **Abramovici,M. ; Breuer,M. ; Friedman, A.** Digital Systems Testing and Testable Design. Computer Science Press, 1990